# EUROPEAN PATENT APPLICATION

(11) **EP 4 709 122 A1**
(43) Date of publication of application: **11.03.2026**
(21) Application number: 24849343.9
(22) Date of filing: 04.06.2024
(51) Int. Cl.: H10K 59/80, H10K 77/10, G09F 9/30, G06F 1/16, G02B 1/14

(54) **FLEXIBLE DISPLAY AND ELECTRONIC DEVICE COMPRISING SAME**

(30) Priority: 28.07.2023 KR 20230099043; 24.08.2023 KR 20230111140
(71) Applicant: Samsung Electronics Co., Ltd., Suwon-si, Gyeonggi-do 16677 (KR)
(72) Inventor: CHO, Hyunmoon, Suwon-si, Gyeonggi-do 16677 (KR); KIM, Ingi, Suwon-si, Gyeonggi-do 16677 (KR); LIM, Kiyul, Suwon-si, Gyeonggi-do 16677 (KR); PARK, Jinhyun, Suwon-si, Gyeonggi-do 16677 (KR); LEE, Hojung, Suwon-si, Gyeonggi-do 16677 (KR)
(74) Representative: Appleyard Lees IP LLP
(86) International application number: PCT/KR2024/007632
(87) International publication number: WO 2025/028772

(57) **Abstract**

A flexible display including a flexible region and a non-flexible region according to one embodiment may comprise: a glass member; a first coating part disposed to surround at least a portion of the surface, including the sides, of the glass member; a second coating part disposed to surround at least a portion of the surface, including the sides, of the first coating part and having a modulus value different from that of the first coating part; and a display panel disposed below the glass member.

## Description

### [Technical Field]

Various embodiments of the disclosure relate to a bendable flexible display and an electronic device including the same.

### [Background Art]

Recently, there is increasing interest in bendable electronic devices (also referred to as 'flexible electronic devices') including a bendable flexible display (simply 'flexible display'). The window member used in the flexible display requires flexibility for preventing deformation when folded or bent as well as impact resistance from surface hardness or strength.

The above-described information may be provided as related art for the purpose of helping understanding of the disclosure. The foregoing cannot be claimed as, or used to determine, the prior art related to the disclosure.

### [Disclosure of Invention]

### [Solution to Problems]

An ultra-thin glass may be used as a glass member provided in a flexible display to secure flexibility. Since ultra-thin glass lacks rigidity, the disclosure may provide a structure that supplements the rigidity of the glass member and reduces the overall thickness of the flexible display.

According to an embodiment, a flexible display including a flexible region and a non-flexible region may include a glass member, a first coating portion disposed to surround at least a portion of surfaces of the glass member including a lateral side of the glass member, a second coating portion disposed to surround at least a portion of surfaces of the first coating portion including a lateral side of the first coating portion and having a modulus value different from the first coating portion, and a display panel disposed under the glass member.

According to an embodiment, an electronic device may include a first housing, a second housing movably coupled to the first housing, and a flexible display disposed in the first housing and the second housing and configured to be at least partially bent according to a position of the second housing relative to the first housing. The flexible display may include a glass member, a first coating portion applied to surround at least a portion of surfaces of the glass member including a lateral side of the glass member, a second coating portion applied to surround at least a portion of surfaces of the first coating portion including a lateral side of the first coating portion and having a modulus value different from the first coating portion, and a display panel disposed under the glass member.

According to various embodiments of the disclosure, the flexible display may double-coat around the glass member and reduce the amount of adhesive members by direct coating and curing, thereby reducing the overall thickness of the flexible display.

According to various embodiments of the disclosure, the flexible display may block foreign objects entering from the sides and reduce damage by double-coating protection of the lateral sides of the glass member.

According to various embodiments of the disclosure, a structure may be provided in which a boundary surface is not visible from the outside by disposing a vertical boundary surface among contact surfaces between two coating layers with different refractive indices under a printed layer.

Effects achievable in example embodiments of the disclosure are not limited to the above-mentioned effects, but other effects not mentioned may be derived and understood by one of ordinary skill in the art to which example embodiments of the disclosure pertain, from the following description. In other words, unintended effects in practicing embodiments of the disclosure may also be derived by one of ordinary skill in the art from example embodiments of the disclosure.

### [Brief Description of Drawings]

FIG. 1 is a view illustrating an electronic device in a network environment according to various embodiments.
FIG. 2A is a perspective view illustrating a foldable electronic device in an unfolding state according to an embodiment.
FIG. 2B is a perspective view of a foldable electronic device in a folding state according to an embodiment.
FIG. 3 is an exploded view illustrating a foldable electronic device according to an embodiment.
FIG. 4 is a perspective view illustrating a stacked structure of a flexible display according to an embodiment.
FIG. 5 is a cross-sectional view illustrating a flexible display according to an embodiment.
FIG. 6 is an enlarged cross-sectional view illustrating a portion of a glass assembly according to an embodiment.
FIGS. 7A to 7E are views illustrating a method for manufacturing a glass assembly of a flexible display according to an embodiment.
FIG. 8 is a cross-sectional view illustrating a flexible display according to an embodiment.
FIG. 9 is a cross-sectional view illustrating a flexible display according to an embodiment.
FIG. 10 is a cross-sectional view illustrating a flexible display according to an embodiment.
FIG. 11 is a cross-sectional view illustrating a flexible display according to an embodiment.
FIGS. 12A to 12C are cross-sectional views illustrating a glass assembly according to an embodiment.
FIGS. 13A to 13C are cross-sectional views illustrating a glass assembly according to an embodiment.
FIGS. 14A to 14C are cross-sectional views illustrating a glass assembly according to an embodiment.
FIGS. 15A to 15C are cross-sectional views illustrating a glass assembly according to an embodiment.

Reference may be made to the accompanying drawings in the following description, and specific examples that may be practiced are shown as examples within the drawings. Other examples may be utilized and structural changes may be made without departing from the scope of the various examples.

### [Mode for the Invention]

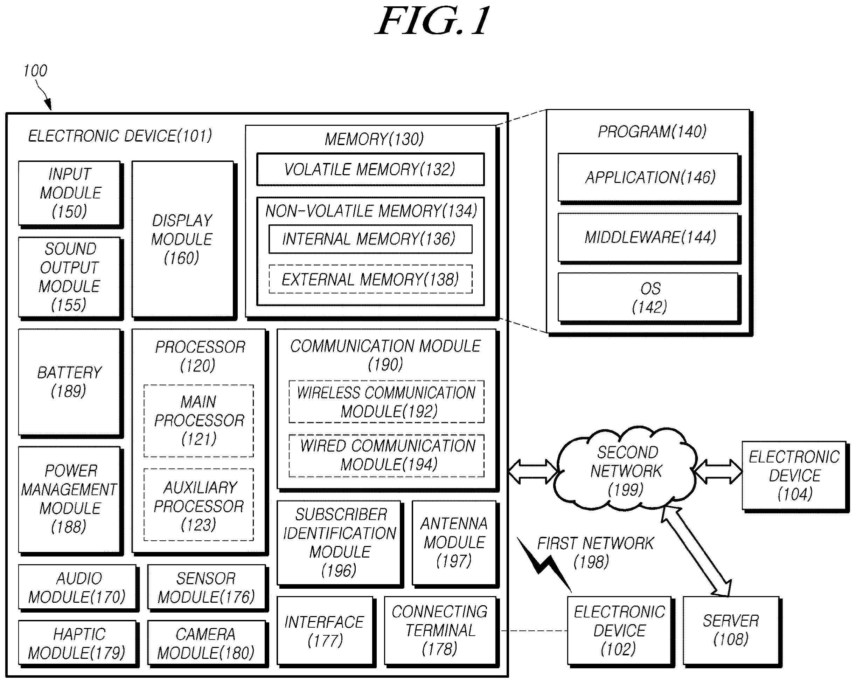

Various embodiments of the disclosure are merely exemplified herein with reference to FIGS. 1 to 15C, to describe the principle of the disclosure, and should not be interpreted as limiting the scope of the disclosure. Those skilled in the art will understand that the principle of the disclosure may be implemented in any appropriately disposed system or device.

Hereinafter, embodiments of the disclosure are described in detail with reference to the drawings so that those skilled in the art to which the disclosure pertains may easily practice the disclosure. However, the disclosure may be implemented in other various forms and is not limited to the embodiments set forth herein. The same or similar reference denotations may be used to refer to the same or similar elements throughout the specification and the drawings. Further, for clarity and brevity, no description is made of well-known functions and configurations in the drawings and relevant descriptions.

FIG. 1 is a block diagram illustrating an electronic device 101 in a network environment 100 according to various embodiments. Referring to FIG. 1, the electronic device 101 in the network environment 100 may communicate with at least one of an electronic device 102 via a first network 198 (e.g., a short-range wireless communication network), or an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In an embodiment, at least one (e.g., the connecting terminal 178) of the components may be omitted from the electronic device 101, or one or more other components may be added in the electronic device 101. According to an embodiment, some (e.g., the sensor module 176, the camera module 180, or the antenna module 197) of the components may be integrated into a single component (e.g., the display module 160).

The processor 120 may execute, for example, software (e.g., the program 140) to control at least one other component (e.g., a hardware or software component) of the electronic device 101 coupled with the processor 120, and may perform various data processing or computation. According to an embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, in case that the electronic device 101 includes the main processor 121 and the auxiliary processor 123, the auxiliary processor 123 may be configured to use lower power than the main processor 121 or to be specified for a designated function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. The artificial intelligence model may be generated via machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by other component (e.g., the processor 120) of the electronic device 101, from the outside (e.g., a user) of the electronic device 101. The input module 150 may include, for example, a microphone, a mouse, a keyboard, keys (e.g., buttons), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor configured to detect a touch, or a pressure sensor configured to measure the intensity of a force generated by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operation state (e.g., power or temperature) of the electronic device 101 or an external environmental state (e.g., the user's state), and then generate an electrical signal or data value corresponding to the detected state. According to an embodiment, the sensor module 176 may include, for example, a gesture sensor, a gyro sensor, an atmospheric pressure sensor, a magnetic sensor, an accelerometer, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, an HDMI connector, a USB connector, an SD card connector, or an audio connector (e.g., a headphone connector).

The haptic module 179 may convert an electrical signal into a mechanical stimulus (e.g., a vibration or motion) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wiredly) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device 104 via a first network 198 (e.g., a short-range communication network, such as Bluetooth^{™}, wireless-fidelity (Wi-Fi) direct, or infrared data association (IrDA)) or a second network 199 (e.g., a long-range communication network, such as a legacy cellular network, a 5G network, a next-generation communication network, the Internet, or a computer network (e.g., local area network (LAN) or wide area network (WAN)). These various types of communication modules may be implemented as a single component (e.g., a single chip), or may be implemented as multiple components (e.g., multiple chips) separate from each other. The wireless communication module 192 may identify or authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device). According to an embodiment, the antenna module 197 may include one antenna including a radiator formed of a conductor or conductive pattern formed on a substrate (e.g., a printed circuit board (PCB)). According to an embodiment, the antenna module 197 may include a plurality of antennas (e.g., an antenna array). In this case, at least one antenna appropriate for a communication scheme used in a communication network, such as the first network 198 or the second network 199, may be selected from the plurality of antennas by, e.g., the communication module 190. The signal or the power may then be transmitted or received between the communication module 190 and the external electronic device via the selected at least one antenna. According to an embodiment, other parts (e.g., radio frequency integrated circuit (RFIC)) than the radiator may be further formed as part of the antenna module 197.

According to various embodiments, the antenna module 197 may form a mmWave antenna module. According to an embodiment, the mmWave antenna module may include a printed circuit board, an RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a lateral side) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, instructions or data may be transmitted or received between the electronic device 101 and the external electronic device 104 via the server 108 coupled with the second network 199. The external electronic devices 102 or 104 each may be a device of the same or a different type from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an Internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

The electronic device according to various embodiments of the disclosure may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

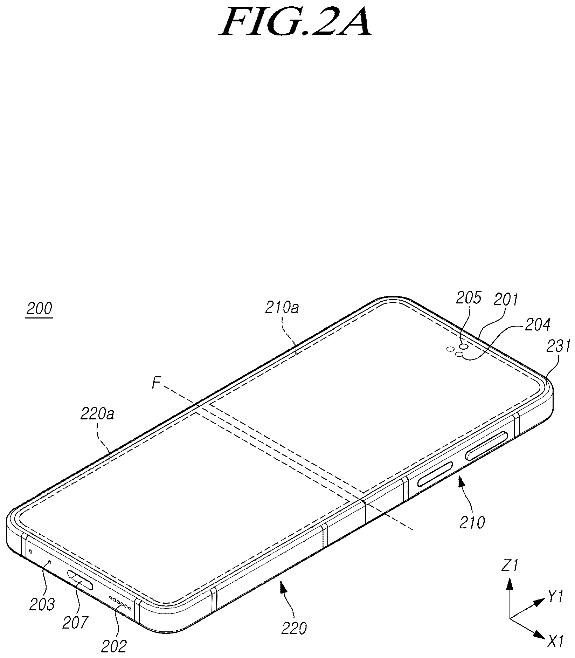

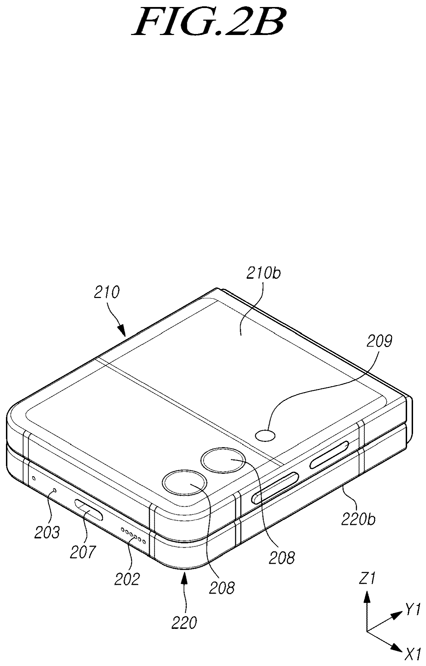

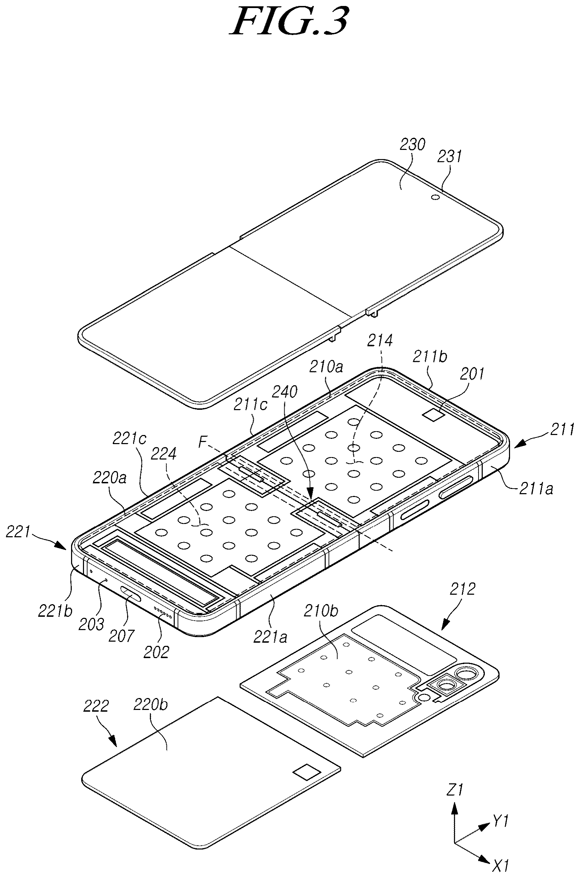

FIG. 2A is a perspective view illustrating a foldable electronic device in an unfolding state according to an embodiment. FIG. 2B is a perspective view of a foldable electronic device in a folding state according to an embodiment. FIG. 3 is an exploded view illustrating a foldable electronic device according to an embodiment. The electronic device shown in FIGS. 2A to 3 is for illustrative purposes, and the disclosure is not limited by the drawings. The XYZ coordinate system shown in FIGS. 2A to 3 is for illustrative purposes of describing the layout of the components and does not limit the scope of the claims.

The electronic device 200 (e.g., the electronic device 101 of FIG. 1) may include at least one pair of housings 210 and 220. The pair of housings 210 and 220 may be rotatably coupled to fold about, e.g., a hinge (e.g., the hinge 240 of FIG. 3) while facing each other. For example, the pair of housings 210 and 220 may include a first housing 210 and a second housing 220. The first housing 210 and the second housing 220 may be disposed on two opposite sides of the folding axis F. One end area of the first housing 210 and one end area of the second housing 220 may be disposed side by side with the hinge 240 interposed therebetween. The first housing 210 and the second housing 220 may have symmetrical shapes with respect to a plane including the folding axis F and extending in the Z1-axis direction. Here, the folding axis F may be an axis in the X1 direction, formed by the hinge 240.

The first housing 210 may have substantially the same length as the second housing 220 (e.g., length in the Y1-axis direction), but is not limited thereto. The first housing 210 may have substantially the same width as the second housing 220 (e.g., width in the X1-axis direction), but is not limited thereto.

Hereinafter, 'unfolding state (or flat state)' or 'unfolded state' may refer to a state in which the angle between the first housing 210 and the second housing 220 is substantially 180 degrees. 'Folding state' or a 'folded state' may refer to a state in which the angle formed between the first housing 210 and the second housing 220 is substantially 0 degrees. 'Intermediate state' may refer to any state between the unfolding state and the folding state. The electronic device 200 may rotate about the hinge 240 such that the first housing 210 and the second housing 220 form an angle from 0 degrees to 180 degrees, for example. The electronic device 200 may rotate about the hinge 240 such that the first housing 210 and the second housing 220 form an angle from 180 degrees to 360 degrees, for example.

The first housing 210 may include a first surface 210a and a second surface 210b. For example, the first surface 210a may be provided to face in a first direction (e.g., +Z1-axis direction). The first surface 210a may be, e.g., a surface on which at least a portion of the flexible display 230 is disposed. The first surface 210a may refer to, e.g., a virtual surface overlapping at least a portion of the flexible display 230. For example, the second surface 210b may be provided to face in a second direction (e.g., -Z1-axis direction). The second surface 210b may be, e.g., a surface on which the first rear cover 212 is disposed. The second surface 210b may be parallel to the first surface 210a. The second surface 210b may refer to a plane defined by, e.g., the first rear cover 212.

The second housing 220 may include a third surface 220a and a fourth surface 220b. For example, the third surface 220a may be provided to face in the first direction (e.g., +Z1-axis direction). The third surface 220a may be, e.g., a surface on which at least a portion of the flexible display 230 is disposed. The third surface 220a may refer to, e.g., a virtual surface overlapping at least a portion of the flexible display 230. For example, the fourth surface 220b may be provided to face in a second direction (e.g., -Z1-axis direction). The fourth surface 220b may be, e.g., a surface on which the second rear cover 222 is disposed. The fourth surface 220b may be parallel to the third surface 220a. The fourth surface 220b may refer to a plane defined by, e.g., the second rear cover 222.

In case that the electronic device 200 is unfolded, the first surface 210a and the third surface 220a may be positioned within one arbitrary virtual plane (e.g., an X1-Y1 plane). For example, the first surface 210a and the third surface 220a may form the same plane in case that the electronic device 200 is unfolded. For example, the first surface 210a and the third surface 220a may be disposed to form 180 degrees with respect to the X1-Y1 plane in the unfolded state. In case that the electronic device 200 is unfolded, the second surface 210b and the fourth surface 220b may be positioned within another arbitrary virtual plane (e.g., an X1-Y1 plane). For example, the second surface 210b and the fourth surface 220b may form the same plane in the unfolded state of the electronic device 200. For example, the second surface 210b and the fourth surface 220b may be disposed to form 180 degrees with respect to the X1-Y1 plane in the unfolded state.

In the folded state of the electronic device 200, at least a portion of the first surface 210a and at least a portion of the third surface 220a may face each other. For example, in the folded state of the electronic device 200, the angle between the first surface 210a and the third surface 220a may be 0 degrees from the X1-Y1 plane. As the electronic device 200 is folded from the unfolded state, the angle between the first surface 210a and the third surface 220a from the X1-Y1 plane may gradually decrease. For example, the angle formed between the first surface 210a and the third surface 220a from the X1-Y1 plane in the intermediate state may be determined between about 0 degrees and about 180 degrees. In the folded state of the electronic device 200, the second surface 210b and the fourth surface 220b may be parallel to each other. For example, the second surface 210b and the fourth surface 220b may face in opposite directions in the folded state of the electronic device 200.

The pair of housings 210 and 220 included in the electronic device 200 is not limited to the shape and coupling shown but may rather be implemented in other shapes or via a combination and/or coupling of other components.

The first housing 210 may include a first side frame 211. The first side frame 211 may include a lateral side of the first housing 210. The first side frame 211 may form part of the exterior of the first housing 210. The first side frame 211 may be provided to protect components received inside the electronic device 200 from the outside.

The first side frame 211 may include a first side member 211a, a second side member 211b, and/or a third side member 211c. The first side member 211a may have a first length along a first length direction (e.g., Y1-axis direction). The second side member 211b may extend from the first side member 211a in a substantially vertical direction (e.g., the X1-axis direction). The second side member 211b may extend to have a second length equal to or different from the first length. The third side member 211c may extend from the second side member 211b in a substantially vertical direction (e.g., the Y1-axis direction). The third side member 211c may extend in a direction substantially parallel to the first side member 211a. The third side member 211c may have a first length along the first length direction (e.g., Y1-axis direction).

The first side member 211a, the second side member 211b, and the third side member 211c may be disposed to be visible from the outside. At least a portion of the first side member 211a, the second side member 211b, and/or the third side member 211c may be formed of a curved surface. The first side frame 211 may be formed in a rectangular (e.g., square or rectangular) shape by the first side member 211a, the second side member 211b, and the third side member 211c. The first side member 211a, the second side member 211b, and the third side member 211c may be integrally formed, but are not limited thereto.

The second housing 220 may include a second side frame 221. The second side frame 221 may include a lateral side of the second housing 220. The second side frame 221 may form part of the exterior of the second housing 220. The second side frame 221 may be provided to protect components received inside the electronic device 200 from the outside.

The second side frame 221 may include a fourth side member 221a, a fifth side member 221b, and/or a sixth side member 221c. The fourth side member 221a may have a third length along a first length direction (e.g., Y1-axis direction). The fifth side member 221b may extend from the fourth side member 221a in a substantially vertical direction (e.g., the X1-axis direction). The fifth side member 221b may extend to have a fourth length equal to or different from the third length. The sixth side member 221c may extend from the fifth side member 221b in a substantially vertical direction (e.g., the Y1-axis direction). The sixth side member 221c may extend in a direction substantially parallel to the fourth side member 221a. The sixth side member 221c may have a third length along the first length direction (e.g., Y1-axis direction).

The fourth side member 221a, the fifth side member 221b, and the sixth side member 221c may be disposed to be visible from the outside. At least a portion of the fourth side member 221a, the fifth side member 221b, and/or the sixth side member 221c may be formed of a curved surface. The second side frame 221 may be formed in a rectangular (e.g., square or rectangular) shape by the fourth side member 221a, the fifth side member 221b, and the sixth side member 221c. The first length may be substantially equal to the third length. The second length may be substantially equal to the fourth length. The fourth side member 221a, the fifth side member 221b, and the sixth side member 221c may be integrally formed, but are not limited thereto.

In the unfolded state of the electronic device 200, the first side member 211a and the fourth side member 221a may be positioned substantially in a straight line. In the unfolded state of the electronic device 200, the second side member 211b and the fifth side member 221b may be parallel to each other. In the unfolded state of the electronic device 200, the third side member 211c and the sixth side member 221c may be positioned substantially in a straight line.

In the folded state of the electronic device 200, the first side member 211a and the fourth side member 221a may overlap each other. In the folded state of the electronic device 200, the second side member 211b and the fifth side member 221b may overlap each other. In the folded state of the electronic device 200, the third side member 211c and the sixth side member 221c may overlap each other.

The first housing 210 may include a first rear cover 212. The first rear cover 212 may form at least a portion of the second surface 210b of the first housing 210. The first rear cover 212 may be combined with the first side frame 211. The first rear cover 212 may be integrally formed with, e.g., the first side frame 211.

The second housing 220 may include a second rear cover 222. The second rear cover 222 may form at least a portion of the fourth surface 220b of the second housing 220. The second rear cover 222 may be combined with the second side frame 221. The second rear cover 222 may be integrally formed with, e.g., the second side frame 221.

The first rear cover 212 and/or the second rear cover 222 may be formed of at least one of, or a combination of at least two of, laminated or colored glass, ceramic, Glastic, polymer, or metal (e.g., aluminum, stainless steel (STS), or magnesium).

The electronic device 200 may include a flexible display 230 (e.g., a foldable display or display). The flexible display 230 may be disposed across the first housing 210, the hinge 240 and the second housing 220. The flexible display 230 may be disposed from the first surface 210a of the first housing 210 across the hinge structure 240 up to at least a portion of the third surface 220a of the second housing 220. The flexible display 230 may be disposed so that the first surface 210a of the first housing 210 and the third surface 220a of the second housing 220 overlap. A portion of the flexible display 230 corresponding to the hinge 240 may be bent according to the rotation of the hinge 240.

In the unfolding state, the flexible display 230 may be disposed to be visible from the outside. In a folding state, the flexible display 230 may be disposed to be invisible from the outside.

The electronic device 200 may include a protective cover 231. The protective cover 231 may be positioned to protect an edge portion of the flexible display 230. The protective cover 231 may form part of the exterior of the electronic device 200.

The electronic device 200 may include at least one of an input device (e.g., the microphone 203), a sound output device (e.g., the receiver 201 for phone calls or speaker 202), sensor modules 204, a camera module (the first camera module 205 or second camera module 208), a connector port 207, a key input device (not shown), or an indicator (not shown), disposed in the first inner space 214 of the first housing 210 or the second inner space 224 of the second housing 220. The electronic device 200 may be configured to omit at least one of the above-described components or add other components.

The input device may include a plurality of microphones disposed to detect the direction of sound. The sound output device may include, e.g., the receiver 201 for phone calls and the speaker 202. The sound output devices 201 and 202 may be disposed to face the outside through at least one speaker hole formed in the first housing 210 or the second housing 220. The connector port 207 may be disposed to face the outside through a connector port hole formed in the first housing 210 or the second housing 220.

The sensor module 204 may produce an electrical signal or data value corresponding to the internal operation state or external environment state of the electronic device 200. The sensor module 204 may include at least one of a proximity sensor, an illuminance sensor, a time of flight (TOF) sensor, an ultrasonic sensor, a fingerprint recognition sensor, a gesture sensor, a gyro sensor, an air pressure sensor, a magnetic sensor, an accelerometer, a grip sensor, a color sensor, an infrared (IR) sensor, a biometric sensor, a temperature sensor, or a humidity sensor.

The camera module may include a first camera module 205 disposed on the front (e.g., surface in the +Z1-axis direction) of the electronic device 200 or a second camera module 208 disposed on the rear side(e.g., surface in the -Z1-axis direction) of the electronic device 200. The first camera module 205 and/or the second camera module 208 may include one or more lenses, an image sensor, and/or an image signal processor. For example, the first camera module 205 may be disposed under the flexible display 230 and be configured to capture a subject through a portion of the active area of the flexible display 230. The flash 209 may be disposed on the second camera module 208. The flash 209 may include, e.g., a light emitting diode (LED) or a xenon lamp.

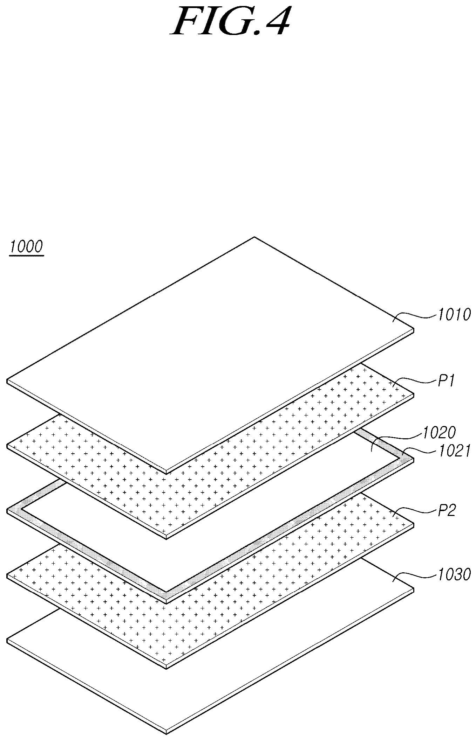

FIG. 4 is a perspective view illustrating a stacked structure of a flexible display according to an embodiment.

The flexible display 1000 illustrated in FIG. 4 may be at least partially similar to a flexible display (e.g., the flexible display 230 of FIG. 2A) provided in the electronic device (e.g., the electronic device 200 of FIG. 2A) described above.

According to an embodiment, the electronic devices 200 having various form factors in which one housing (e.g., the first housing 210 of FIG. 2A) moves with respect to another housing (e.g., the second housing 220 of FIG. 2A) may include the flexible display 1000 illustrated in FIG. 4.

According to an embodiment, the flexible display 1000 may be disposed to traverse at least the first housing 210 and the second housing 220. Therefore, as the second housing 220 moves with respect to the first housing 210, at least a portion of the flexible display 1000 may be bent.

According to an embodiment, the flexible display 1000 may include a flexible region and a non-flexible region. The flexible region and the non-flexible region may be configured in various shapes and numbers according to the form factor of the electronic device 200 on which the flexible display 1000 is mounted. The flexible region may refer to a region bent according to the electronic device 200. The non-flexible region may refer to a region other than the flexible region, a region that is not bent or maintains a flat surface.

Referring to FIG. 4, the flexible display 1000 may include a protective member 1010 (e.g., a protective film), a glass assembly 1020, and a display panel 1030. According to an embodiment, the flexible display 1000 may be configured such that the protective member 1010, the glass assembly 1020, and the display panel 1030 are sequentially stacked from above. Each component may be adhered by adhesive members P1, P2, but the disclosure is not limited thereto.

The adhesive members P1, P2 may include at least one of an optically clear adhesive (OCA) film, an optically clear resin (OCR), a pressure sensitive adhesive (PSA) film, a heat-reactive adhesive, a general adhesive, or a double-sided tape. The adhesive members P1, P2 include a light-curing adhesive material or a thermosetting adhesive material, and the material thereof is not particularly limited. The adhesive members P1, P2 may include, e.g., at least one of a first adhesive member P1 provided to adhere the protective member 1010 and the glass assembly 1020, and a second adhesive member P2 provided to adhere the glass assembly 1020 and the display panel 1030.

The configuration illustrated in FIG. 4 is exemplary for convenience of description, and the flexible display 1000 may further include additional configurations. For example, although not illustrated, various types of layers such as a polarizer (e.g., a polarizing film) or a touch sensing layer may be provided above the display panel 1030. The touch sensing layer may be configured to obtain coordinate information of an external input. The touch sensing layer may be, e.g., a capacitive touch sensing member. However, this is not limited thereto, and may be replaced with other types of touch sensing layers including two types of touch electrodes, such as an electromagnetic induction method.

According to an embodiment, the display panel 1030 may be disposed under the glass assembly 1020. The display panel 1030 may be an organic light emitting display panel, an electrophoretic display panel, an electrowetting display panel, or a quantum dot display panel, but the type is not limited. A light emitting layer of the organic light emitting display panel may include an organic light emitting material. A light emitting layer of the quantum dot display panel may include quantum dots and quantum rods. The display panel 1030 may be formed such that at least a portion thereof is bendable. For example, the display panel 1030 may be formed such that at least a portion thereof is deformable.

According to an embodiment, the glass assembly 1020 may be disposed on the display panel 1030. The glass assembly 1020 may be attached to directly contact the display panel 1030. However, without limitation thereto, various types of layers such as a polarizing layer (not illustrated) or a touch sensing layer (not illustrated) may be provided between the glass assembly 1020 and the display panel 1030.

According to an embodiment, the glass assembly 1020 may include a printed layer 1021. The printed layer 1021 may be disposed in at least a partial region of the flexible display (e.g., the flexible display 1000 of FIG. 4). For example, the printed layer 1021 may be disposed near the corners of the glass assembly 1020. The printed layer 1021 may be disposed on the upper side of the glass assembly 1020. According to an embodiment, the printed layer 1021 may be disposed along the corners of the glass assembly 1020 to have a substantially rectangular shape. For example, the printed layer 1021 may be formed along the edges of the glass assembly 1020. The printed layer 1021 may be disposed by being impregnated or penetrated into the upper side of the glass assembly 1020.

According to an embodiment, the printed layer 1021 may be an edge of a display area visible from the outside if the flexible display 1000 is disposed in the electronic device (e.g., the electronic device 200 of FIG. 2A). The printed layer 1021 may be formed along the edge portion of the glass assembly 1020, but the disclosure is not limited thereto. For example, the printed layer 1021 may form a bezel pattern. The printed layer 1021 may include, e.g., a light-blocking material through which light does not transmit.

The printed layer 1021 may be disposed such that at least a portion thereof overlaps at least partially with a display area visible from the outside in case that the flexible display 1000 is disposed in the electronic device 200. For example, the printed layer 1021 may be visible such that at least a portion thereof is visible from the outside in case that the flexible display 1000 is disposed in the electronic device 200.

The printed layer 1021 may have a width of, e.g., 1 mm or less, but the disclosure is not limited thereto.

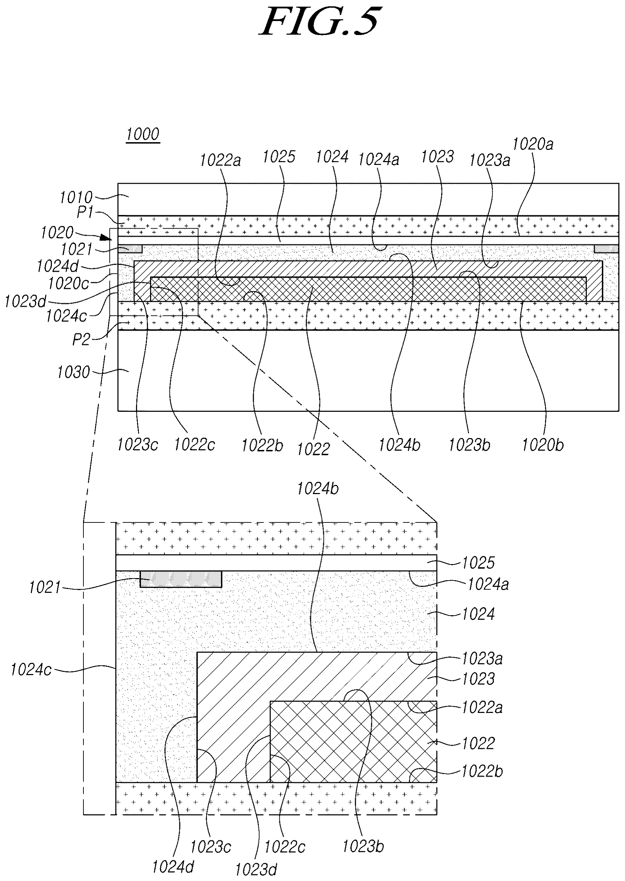

A detailed description of the glass assembly 1020 is described below in FIG. 5.

According to an embodiment, the protective member 1010 (e.g., a protective film) may be disposed on the uppermost layer of the flexible display 1000. The protective member 1010 may be disposed above the glass assembly 1020 to protect a thin glass member (e.g., the glass member 1022 of FIG. 5), which is a component of the glass assembly 1020, from external impacts. The protective member 1010 may protect the glass member 1022 from external impacts and help reduce glass fragments from scattering in case that the glass member 1022 is broken.

The protective member 1010 and the glass assembly 1020 may be adhered by the first adhesive member P1. As the protective member 1010 and the glass assembly 1020 are adhered to each other, the first adhesive member P1 may be disposed between the protective member 1010 and the glass assembly 1020.

According to an embodiment, the protective member 1010 may be detachably attached to the glass assembly 1020. In case that the protective member 1010 is damaged by external impact or the like, a new protective member 1010 may be attached on the glass assembly 1020. Therefore, the adhesive force of the first adhesive member P1 may be weaker than the adhesive force of the second adhesive member P2.

According to an embodiment, the protective member 1010 may include polyethylene terephthalate (PET) or polyimide (PI), but is not limited thereto and may include materials used for polymer members to be described below.

Although not illustrated, a polymer member may be disposed under the display panel 1030. The polymer member may, e.g., have a dark color applied to help background visualization in case that the display is off. The polymer member may act as a cushioning member to reduce damage to the flexible display 1000 by absorbing impacts from outside the electronic device.

The polymer member may include a plastic film as a base layer. The polymer member may include a plastic film including any one selected from the group comprising polyethersulphone (PES), polyacrylate (PAR), polyetherimide (PEI), polyethylene naphthalate (PEN), polyethylene terephthalate (PET), polyphenylene sulphide (PPS), polyarylate, polyimide (PI), polycarbonate (PC), or combinations thereof.

Although not illustrated, a metal sheet layer may be disposed under the display panel 1030. The metal sheet layer may help reinforce the rigidity of the electronic device. The metal sheet layer may be used, e.g., to shield ambient noise and disperse heat emitted from surrounding heat-emitting components. The metal sheet layer may include at least one of stainless steel (STS), Cu, Al, or other alloy materials.

FIG. 5 is a cross-sectional view illustrating a flexible display according to an embodiment.

FIG. 5 may be a cross-sectional view for describing the stacked structure of the flexible display 1000 of FIG. 4. The stacked structure of the flexible display 1000 of FIG. 5 is exemplary, and the scope of the disclosure is not limited by the illustrated stacked structure, and various types of layers such as a polarizing layer and a touch sensing layer may be additionally disposed between each component. Among the configurations illustrated in FIG. 5, the same reference numerals are used for configurations substantially the same or similar to those described in connection with FIG. 5.

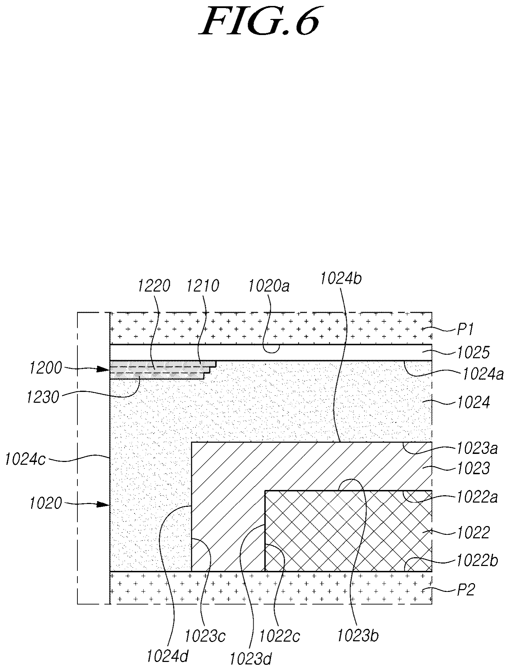

The embodiment of FIG. 5 may be selectively combined with the embodiments of FIGS. 6 to 15C.

Referring to FIG. 5, in the flexible display 1000, the glass assembly 1020 and the protective member 1010 may be sequentially stacked on the display panel 1030. The protective member 1010 may be stacked on the glass assembly 1020.

According to an embodiment, the glass assembly 1020 may include at least one of a printed layer 1021, a glass member 1022, a first coating portion 1023, or a second coating portion 1024.

According to an embodiment, the glass assembly 1020 may include a first surface 1020a as an upper side, a second surface 1020b as a lower surface, and a third surface 1020c as a lateral side connecting the first surface 1020a and the second surface 1020b. The first surface 1020a may be a surface to which the first adhesive member P1 is adhered. The first surface 1020a may be a surface facing the protective member 1010. The first surface 1020a may be, e.g., the same plane as the upper side 1024a of the second coating portion 1024, but the disclosure is not limited thereto. The second surface 1020b may be a surface to which the second adhesive member P2 is adhered. The second surface 1020b may be a surface facing the display panel 1030.

According to an embodiment, the printed layer 1021 may be disposed on the upper side 1024a of the second coating portion 1024. The printed layer 1021 may be disposed along the corners of the second coating portion 1024 to have a substantially rectangular shape. For example, the printed layer 1021 may be formed along the edges of the second coating portion 1024.

According to an embodiment, the printed layer 1021 may be configured not to protrude from the first surface 10200a. The printed layer 1021 may be configured such that a surface facing upward forms substantially the same plane as the first surface 1020a of the glass assembly 1020. The printed layer 1021 may be disposed, e.g., by being impregnated or penetrated into the second coating portion 1024 so as not to protrude upward. The surface facing upward of the printed layer 1021 may be configured to form substantially the same plane as the upper side of the second coating portion 1024. By disposing the printed layer 1021 to be impregnated or penetrated into the second coating portion 1024, a component (e.g., the hard coating layer 1025) disposed or attached on the second coating portion 1024 may be provided on the flat first surface 1020a of the glass assembly 1020.

According to an embodiment, if the printed layer 1021 is disposed on the second coating portion 1024, bubbles may be generated due to the step between the printed layer 1021 and the second coating portion 1024, which may cause defects or damage. In the disclosure, by disposing the printed layer 1021 to overlap the second coating portion 1024 in a substantially horizontal direction, the step between the printed layer 1021 and the hard coating layer 1025 may be eliminated.

According to an embodiment, since the printed layer 1021 is impregnated or penetrated into the second coating portion 1024, a step may be formed in relation to the second coating portion 1024. Due to this step, bubbles may occur, which may reduce the durability of the flexible display 1000. For example, to reduce bubble generation between the printed layer 1021 and the second coating portion 1024, the thickness of the printed layer 1021 may be 5 microns or less, but the disclosure is not limited thereto.

According to an embodiment, the glass member 1022 may include an upper side 1022a, a lower side1022b facing the opposite direction of the upper side 1022a, and a lateral side 1022c connecting the upper side 1022a and the lower side1022b. The lower side1022b of the glass member 1022 may form, e.g., a portion of the second surface 1020b of the glass assembly 1020, but the disclosure is not limited thereto.

At least a portion of the surfaces of the glass member 1022 may be wrapped by the first coating portion 1023. For example, a portion of the first coating portion 1023 may be attached or bonded to the lateral side 1022c of the glass member 1022. The first coating portion 1023 may be attached or bonded to the upper side 1022a of the glass member 1022 as illustrated. However, without limitations thereto, and the first coating portion 1023 may also be attached or bonded to the lower side1022b of the glass member 1022.

According to an embodiment, the glass member 1022 may have a planar area smaller than the display panel 1030 or the protective member 1010. For example, the area of the upper side 1022a of the glass member 1022 may be smaller than the area of the display panel 1030 or the protective member 1010. In case that the first coating portion 1023 and the second coating portion 1024 are omitted, the glass member 1022 may have a stepped structure in which the lateral side (or edge) is recessed inward with respect to the edge of the display panel 1010 and the edge of the protective member 1010 during stacking due to this area difference. For example, a groove may be formed between the edge of the display panel 1030 and the edge of the protective member 1010 due to the area difference of the glass member 1022. In case that minute-sized foreign objects enter the inwardly recessed stepped structure (or groove), the glass member 1022 may be damaged. In the disclosure, the first coating portion 1023 may wrap the lateral side 1022c of the glass member 1022 to reduce damage to the glass member 1022.

According to an embodiment, the glass member 1022 may be provided to protect the display panel 1030 from external impacts. The glass member 1022 may protect the display panel from being damaged or malfunctioning due to external impacts by transmitting images from the display panel 1030 while simultaneously mitigating external impacts. Here, external impact refers to a force applied from the outside such as pressure or stress, which may cause damage to the display panel 1030.

According to an embodiment, the glass member 1022 may have a thickness of 20 micrometers to 150 micrometers, but the disclosure is not limited thereto. For example, the glass member 1022 may be 25 micrometers to 35 micrometers. The glass member 1022 may include ultra-thin glass (UTG) or polyimide (PI).

According to an embodiment, the first coating portion 1023 may be disposed to surround the lateral side 1022c of the glass member 1022. A portion of the first coating portion 1023 may be bonded to the lateral side 1022c of the glass member 1022. The first coating portion 1023 may be disposed to surround at least a portion of the surfaces of the glass member 1022 including the lateral side of the glass member 1022.

The first coating portion 1023 may be disposed such that a portion thereof contacts at least one of the upper side 1022a or the lower side1022b of the glass member 1022. A portion of the first coating portion 1023 may be bonded or attached to the upper side 1022a or the lower side1022b of the glass member 1022. For example, in case that a portion of the first coating portion 1023 is disposed on the upper side 1022a and the lower side1022b of the glass member 1022, the first coating portion 1023 may be disposed to wrap all surfaces of the glass member 1022.

According to an embodiment, the first coating portion 1023 may include a first coating upper side 1023a, a first coating lower side1023b facing opposite to the first coating upper side 1023a, a 1-1th coating lateral side 1023c (or outer side) extending in a vertical direction from the edge of the first coating upper side 1023a, and a 1-2th coating lateral side 1023d (or inner side) extending in a vertical direction from the edge of the first coating lower side1023b. The area of the first coating upper side 1023a may be larger than the area of the first coating lower side1023b. The 1-1th coating lateral side 1023c may be substantially parallel to the 1-2th coating lateral side 1023d. The 1-1th coating lateral side 1023c and the 1-2th coating lateral side 1023d may extend in a direction substantially parallel to a direction perpendicular to the front side of the flexible display 1000. The 1-1th coating lateral side 1023c may be positioned outside of the 1-2th coating lateral side 1023d.

The first coating upper side 1023a may be a surface in contact with the second coating portion 1024. For example, the first coating upper side 1023a may contact the second coating lower side1024b of the second coating portion 1024.

The first coating lower side1023b may be a surface in contact with the glass member 1022. For example, the first coating lower side1023b may contact the upper side 1022a of the glass member 1022.

The 1-1th coating lateral side 1023c may be a surface in contact with the second coating portion 1024. For example, the 1-1th coating lateral side 1023c may contact the 2-2th coating lateral side 1024d of the second coating portion 1024.

The 1-2th coating lateral side 1023d may be a surface in contact with the glass member 1022. For example, the 1-2th coating lateral side 1023d may contact the lateral side 1022c of the glass member 1022.

According to an embodiment, the refractive index of the first coating portion 1023 may be substantially the same as the refractive index of the glass member 1022. The first coating portion 1023 may be refractive index matched with the glass member 1022. By matching the refractive index of the first coating portion 1023 and the refractive index of the glass member 1022, the boundary surface between the first coating portion 1023 and the glass member 1022 may be inhibited from being visible from the outside. For example, the boundary surface formed on the lateral side 1022c of the glass member 1022, which extends about perpendicular to the front side of the flexible display 1000, may be inhibited from being visible from the outside through refractive index matching between the first coating portion 1023 and the glass member 1022.

According to an embodiment, the first coating portion 1023 and the second coating portion 1024 may have different elastic modulus (modulus values). According to an embodiment, the first coating portion 1023 may have a relatively smaller modulus value than the second coating portion 1024. The first coating portion 1023 may have, e.g., relatively more flexible performance than the second coating portion 1024.

According to an embodiment, the first coating portion 1023 may be an elastic material. For example, the first coating portion 1023 may include acrylic, urethane, or silicone material, but the disclosure is not limited thereto. The glass assembly 1020 may secure bending durability by the elasticity of the first coating portion 1023. Bending durability may refer to performance that is not damaged even with repeated bending of the flexible display 1000. The first coating portion 1023 may be, e.g., optically clear resin (OCR). The first coating portion 1023 may be referred to as, e.g., a first coating layer or a first elastic coating layer.

According to an embodiment, the second coating portion 1024 may be disposed to surround the lateral side (e.g., the 1-1th coating lateral side 1023c or outer side) of the first coating portion 1023. A portion of the second coating portion 1024 may be bonded to the lateral side (e.g., the 1-1th coating lateral side 1023c or outer side) of the first coating portion 1023. The second coating portion 1024 may be disposed to surround surfaces including the lateral side (e.g., the 1-1th coating lateral side 1023c or outer side) of the first coating portion 1023.

The second coating portion 1024 may be disposed such that a portion thereof contacts the first coating upper side 1023a of the first coating portion 1023. A portion of the second coating portion 1024 may be bonded or attached to the first coating upper side 1023a of the first coating portion 1023. For example, unlike illustrated, the second coating portion 1024 may be disposed to wrap the entire outside of the first coating portion 1023 and the glass member 1022.

According to an embodiment, the second coating portion 1024 may include a second coating upper side 1024a, a second coating lower side1024b facing opposite to the second coating upper side 1024a, a 2-1th coating lateral side 1024c (or outer side) extending in a vertical direction from the edge of the second coating upper side 1024a, and a 2-2th coating lateral side 1024d (or inner side) extending in a vertical direction from the edge of the second coating lower side1024b. The area of the second coating upper side 1024a may be larger than the area of the second coating lower side1024b. The 2-1th coating lateral side 1024c may be substantially parallel to the 2-2th coating lateral side 1024d. The 2-1th coating lateral side 1024c and the 2-2th coating lateral side 1024d may extend in a direction substantially parallel to a direction perpendicular to the front side of the flexible display 1000. The 2-1th coating lateral side 1024c may be positioned outside of the 2-2th coating lateral side 1024d.

The second coating upper side 1024a may be a surface in contact with the hard coating layer 1025. For example, the second coating upper side 1024a may be substantially the same portion as the first surface 1020a of the glass assembly 1020.

The second coating lower side1024b may be a surface in contact with the first coating portion 1023. For example, the second coating lower side1024b may contact the first coating upper side 1023a of the first coating portion 1023.

The 2-1th coating lateral side 1024c may be the outermost surface of the glass assembly 1020. For example, the 2-1th coating lateral side 1024c may be substantially the same portion as the third surface 1020c of the glass assembly 1020.

The 2-2th coating lateral side 1024d may be a side in contact with the first coating portion 1023. For example, the 2-2th coating lateral side 1024d may contact the 1-1th coating lateral side 1023c of the first coating portion 1023.

According to an embodiment, the second coating portion 1024 may have a relatively larger modulus value than the first coating portion 1023. The second coating portion 1024 may have, e.g., relatively greater rigidity than the first coating portion 1023. By disposing the second coating portion 1024 to wrap the first coating upper side 1023a and the 1-1th coating lateral side 1023c of the first coating portion 1023, the second coating portion 1024 may protect the first coating portion 1023 and the glass member 1022 disposed within the second coating portion 1024 from external impacts.

A relatively greater adhesive force may be formed on the first coating portion 1023 having a relatively smaller modulus value than the second coating portion 1024. Due to this adhesive force, external foreign objects may adhere to the first coating portion 1023 and damage the glass assembly 1020. If the second coating portion 1024 wraps the outside of the first coating portion 1023, the first coating portion 1023 is spatially separated from the external air layer, reducing damage by foreign objects to the first coating portion 1023. For example, the second coating portion 1024 may have a modulus of 0.1 MPa or more.

According to an embodiment, as the second coating portion 1024 having a relatively larger modulus value than the first coating portion 1023 wraps the outside of the first coating portion 1023, the second coating portion 1024 may constrain the deformation of the first coating portion 1023.

According to an embodiment, the second coating portion 1024 may be an elastic material. For example, the second coating portion 1024 may include acrylic, urethane, or silicone material, but the disclosure is not limited thereto. The glass assembly 1020 may secure bending durability by the elasticity of the second coating portion 1024. Bending durability may refer to performance that is not damaged even with repeated bending of the flexible display 1000. The second coating portion 1024 may be, e.g., optically clear resin (OCR). The second coating portion 1024 may be referred to as, e.g., a second coating layer or a second elastic coating layer.

According to an embodiment, the 1-1th coating lateral side 1023c (e.g., outer side) of the first coating portion 1023 may be disposed to vertically overlap the printed layer 1021. The 1-1th coating lateral side 1023c (e.g., outer side) of the first coating portion 1023 may be disposed not to be visible from the outside by being hidden by the printed layer 1021. The 1-1th coating lateral side 1023c (e.g., outer side) of the first coating portion 1023 is a boundary side in contact with the 2-2th coating lateral side 1024d (e.g., inner side) of the second coating portion 1024, and may be a side substantially parallel to a direction perpendicular to the front side of the flexible display 1000.

Since the first coating portion 1023 and the second coating portion 1024 have different roles and are configured with different modulus values, there may be a difference in refractive index between the first coating portion 1023 and the second coating portion 1024. Due to the difference in refractive index between the first coating portion 1023 and the second coating portion 1024, there is a problem that the 1-1th coating lateral side 1023c (e.g., outer side) of the first coating portion 1023 is visible from the outside, degrading aesthetics. In the disclosure, by positioning the 1-1th coating lateral side 1023c (e.g., outer side) of the first coating portion 1023 to vertically overlap the printed layer 1021, the boundary surface may be inhibited from being visible from the outside.

According to an embodiment, among the surfaces where the first coating portion 1023 and the second coating portion 1024 contact, a surface substantially perpendicular to the front side of the flexible display 1000 may be disposed to overlap the printed layer 1021. According to an embodiment, the printed layer 1021 may be disposed to overlap a surface substantially perpendicular to the front side of the flexible display 1000 among the surfaces where the first coating portion 1023 and the second coating portion 1024 contact. According to an embodiment, the printed layer 1021 may be disposed such that a virtual plane including a surface substantially perpendicular to the front side of the flexible display 1000 among the surfaces where the first coating portion 1023 and the second coating portion 1024 contact passes through.

According to an embodiment, among the surfaces where the first coating portion 1023 and the second coating portion 1024 contact, a surface extending in a direction substantially perpendicular to the front side of the flexible display 1000 (e.g., the 1-1th lateral side 1023c (e.g., outer side) of the first coating portion 1023 or the 2-2th lateral side 1024d (e.g., inner side) of the second coating portion 1024) may be disposed to vertically overlap the printed layer 1021.

According to an embodiment, the 2-2th coating lateral side 1024d (e.g., inner side) of the second coating portion 1024 may be disposed to vertically overlap the printed layer 1021. According to an embodiment, the printed layer 1021 may be disposed to vertically overlap the 1-1th coating lateral side 1023c (e.g., outer side) of the first coating portion 1023. According to an embodiment, the printed layer 1021 may be disposed to vertically overlap the 2-2th coating lateral side 1024d (e.g., inner side) of the second coating portion 1024.

According to an embodiment, the first coating portion 1023 and the second coating portion 1024 may be formed of a hyper elastic material. In the disclosure, by double coating the first coating portion 1023 and the second coating portion 1024 with different modulus values, wrinkle phenomena occurring in bent (rolled or folded) portions may be mitigated.

According to an embodiment, the glass assembly 1020 may further include a hard coating layer 1025. The hard coating layer 1025 may be disposed on the glass assembly 1020 to protect the surface of the glass assembly 1020. For example, the hard coating layer 1025 may be disposed on the second coating portion 1024 to protect the surface of the second coating portion 1024. The hard coating layer 1025 may be a transparent material. According to an embodiment, the configuration of the hard coating layer 1025 may be omitted.

FIG. 6 is an enlarged cross-sectional view illustrating a portion of a glass assembly according to an embodiment.

The glass assembly 1020 of FIG. 6 may be included in the flexible display (e.g., the flexible display 1000 of FIG. 4) of FIGS. 4 and 5. Among the configurations of the glass assembly 1020 illustrated in FIG. 6, the same reference numerals are used for configurations substantially the same or similar to the glass assembly 1020 of FIG. 5.

The embodiment of FIG. 6 may be selectively combined with the embodiments of FIGS. 5 and 8 to 15C.

Referring to FIG. 6, the glass assembly 1020 may include a printed layer 1200 having a multi-stage structure. The printed layer 1200 with a multi-stage structure may be configured such that the width gradually narrows as it moves away from the first surface 1020a of the glass assembly 1020. The printed layer 1200 with a multi-stage structure may be configured such that the width gradually narrows as it moves away from the second coating upper side 1024a of the second coating portion 1024. By forming a multi-stage structure as illustrated, the size of each step may be decreased, and as a result, circumstances where empty spaces or bubbles are formed between the printed layer 1200 and the second coating portion 1024 due to the step may be decreased.

According to an embodiment, the printed layer 1200 may include a first printed layer 1210, a second printed layer 1220, and a third printed layer 1230. For example, the first printed layer 1210, the second printed layer 1220, and the third printed layer 1230 may have different widths. The first printed layer 1210 may have a larger width than the second printed layer 1220. The second printed layer 1220 may have a larger width than the third printed layer 1230. The size or length of the first printed layer 1210, the second printed layer 1220, or the third printed layer 1230 is not limited to what is illustrated, and may form various sizes, lengths, or thicknesses. For example, at least two printed layers among the first printed layer 1210, the second printed layer 1220, or the third printed layer 1230 may have the same size or length.

According to an embodiment, the first printed layer 1210, the second printed layer 1220, or the third printed layer 1230 may be formed of the same material. However, without limitations thereto, and the materials of each of the first printed layer 1210, the second printed layer 1220, or the third printed layer 1230 may be formed differently or at least partially formed with the same configuration.

The three-stage structure printed layer 1200 illustrated in FIG. 6 is exemplary and not limited thereto. For example, the multi-stage structure printed layer 1200 may have a two-stage structure or a structure of four or more stages.

The first printed layer 1210, the second printed layer 1220, and the third printed layer 1230 may be sequentially disposed from the first surface 1020a of the glass assembly 1020. The first printed layer 1210, the second printed layer 1220, and the third printed layer 1230 may have a vertically stacked structure.

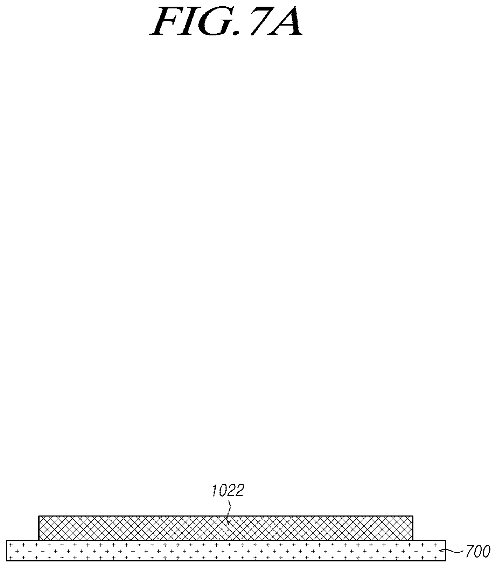

FIGS. 7A to 7E are views illustrating a method for manufacturing a glass assembly of a flexible display according to an embodiment.

The glass assembly 1020 manufactured by the process illustrated in FIGS. 7A to 7E may be substantially the same or similar to the glass assembly 1020 illustrated in FIGS. 4 and 5. Among the configurations of the glass assembly 1020 illustrated in FIGS. 7A to 7E, the same reference numerals are used for configurations substantially the same or similar to the configurations of the glass assembly 1020 illustrated in FIGS. 4 and 5.

Referring to FIG. 7A, a glass member 1022 may be attached on a release film 700. The release film 700 may be provided to reduce damage such as scratches from occurring on the surface of the glass member 1022 during the manufacturing process.

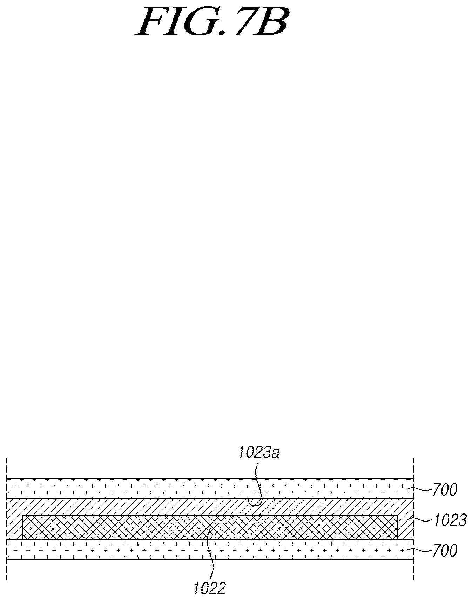

Referring to FIG. 7B, a first coating portion 1023 may be applied and cured on the outside of the glass member 1022. A release film 700 for protecting the first coating upper side 1023a of the first coating portion 1023 may be attached on the first coating portion 1023. The first coating portion 1023 may be applied to wrap, e.g., the upper side and lateral side of the glass member 1022. After the curing of the first coating portion 1023 is completed, the outer side of the first coating portion 1023 may be punched by laser or the like. A vertical surface may be formed by punching the outer side of the first coating portion 1023.

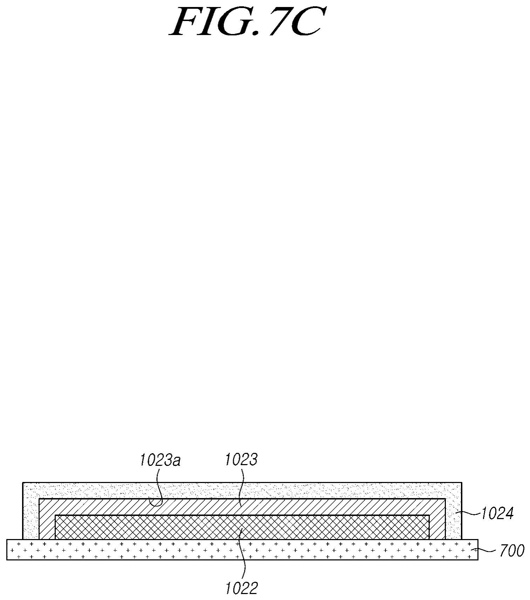

Referring to FIG. 7C, a second coating portion 1024 may be applied on the outside of the first coating portion 1023. The second coating portion 1024 may be applied to wrap, e.g., the upper side and outer side of the first coating portion 1023.

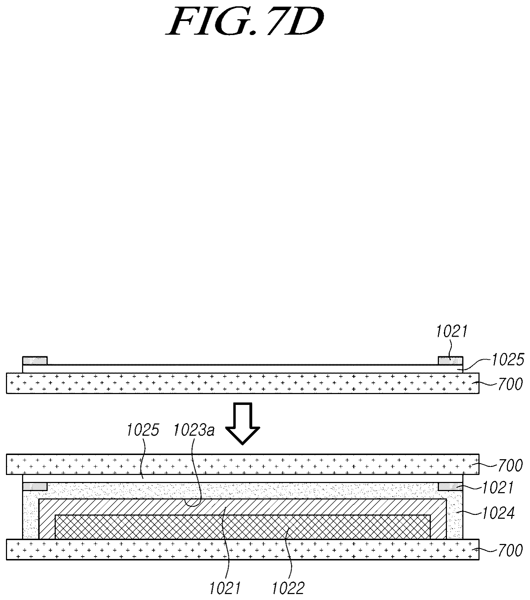

Referring to FIG. 7D, a hard coating layer 1025 printed with a printed layer 1021 may be loaded or disposed on the second coating portion 1024. If the printed layer 1021 is printed on the hard coating layer 1025 and then disposed on the second coating portion 1024, the printed layer 1021 may be impregnated or penetrated on the second coating portion 1024 that has not yet been cured. Then, if the second coating portion 1024 is cured, the printed layer 1021 may be cured in a state impregnated or penetrated into the second coating portion 1024. In this case, the hard coating layer 1025 may be in film form.

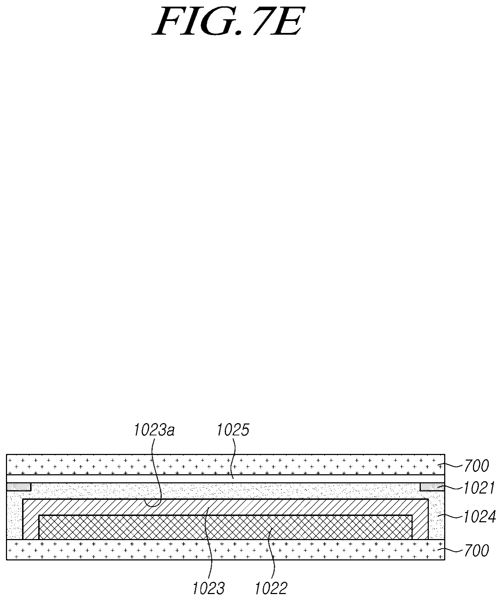

Referring to FIG. 7E, after curing the second coating portion 1024, the outer side of the second coating portion 1024 may be punched. A vertical lateral side may be formed by punching the outer side of the second coating portion 1024.

In the disclosure, since the glass member 1022, the first coating portion 1023, and the second coating portion 1024 are manufactured by direct coating and curing, separate adhesive members between each member may be omitted. Accordingly, the overall thickness of the flexible display (e.g., the flexible display 1000 of FIG. 4) may be decreased.

The glass assembly 1020 according to an embodiment of the disclosure may be manufactured by the process of FIGS. 7A to 7E, thereby double coating the lateral side of the glass member 1022 using the first coating portion 1023 and the second coating portion 1024 to protect the side portion vulnerable to damage of the glass member 1022.

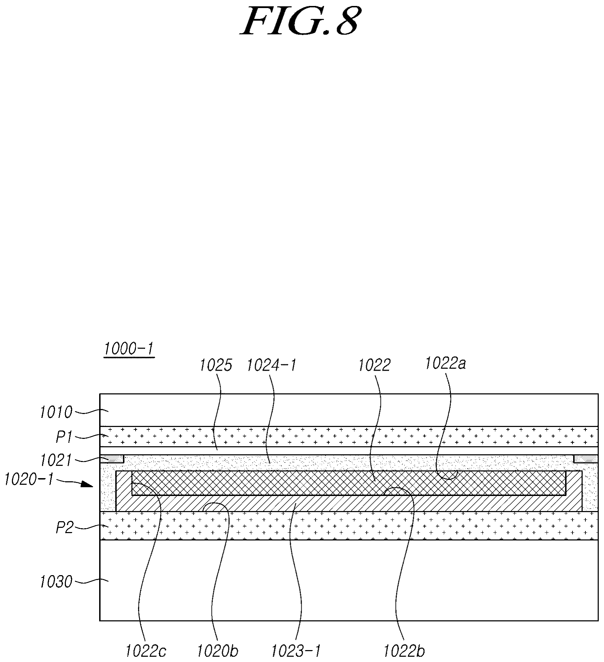

FIG. 8 is a cross-sectional view illustrating a flexible display according to an embodiment.

The flexible display 1000-1 of FIG. 8 may be included or disposed in the electronic device (e.g., the electronic device 200 of FIG. 2A). The glass assembly 1020-1 of FIG. 8 may be included in the flexible display (e.g., the flexible display 1000 of FIG. 4) of FIGS. 4 and 5. However, the disclosure is not limited thereto.

Among the configurations illustrated in FIG. 8, the same reference numerals are used for configurations substantially the same or similar to the configurations of the flexible display (e.g., the flexible display 1000 of FIG. 4) of FIGS. 4 and 5.

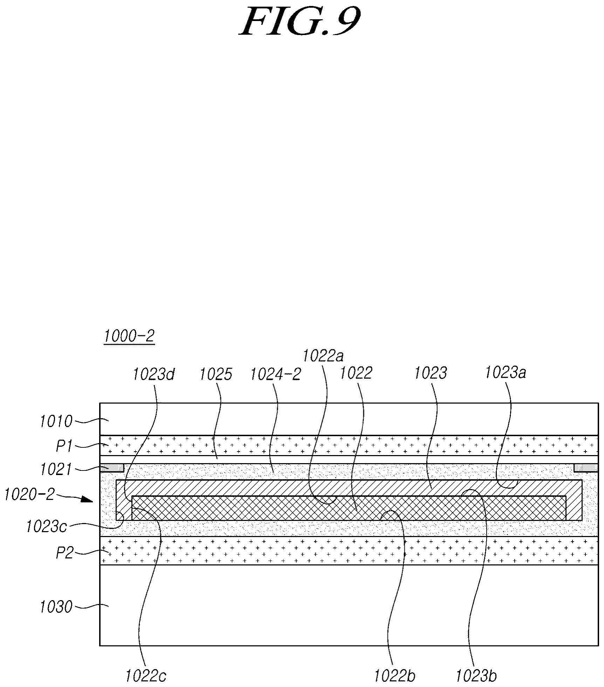

The embodiment of FIG. 8 may be selectively combined with the embodiments of FIGS. 5 to 7E. The embodiment of FIG. 8 may be selectively combined with the embodiments of FIGS. 9 to 15C.

According to an embodiment, in the flexible display 1000-1, the glass assembly 1020-1 and the protective member 1010 may be sequentially stacked on the display panel 1030. The protective member 1010 may be stacked on the glass assembly 1020-1.

According to an embodiment, the glass assembly 1020-1 may include at least one of a printed layer 1021, a glass member 1022, a first coating portion 1023-1, or a second coating portion 1024-1. The glass assembly 1020-1 may include, e.g., a multi-stage format printed layer 1200 as illustrated in FIG. 6.

According to an embodiment, the glass member 1022 may include an upper side 1022a, a lower side1022b facing the opposite direction of the upper side 1022a, and a lateral side 1022c connecting the upper side 1022a and the lower side1022b. The lower side1022b of the glass member 1022 may form, e.g., a portion of the second surface 1020b of the glass assembly 1020-1, but the disclosure is not limited thereto.

At least a portion of the surfaces of the glass member 1022 may be wrapped by the first coating portion 1023-1. For example, a portion of the first coating portion 1023-1 may be attached or bonded to the lateral side 1022c of the glass member 1022. The first coating portion 1023-1 may be attached or bonded to the lower side1022b of the glass member 1022 as illustrated. The first coating portion 1023-1 may be disposed such that a portion thereof contacts the lower side1022b of the glass member 1022. Unlike illustrated in FIG. 5, by applying the first coating portion 1023-1 to the lower side1022b rather than the upper side 1022a of the glass member 1022, impacts applied from below the glass member 1022 may be mitigated.

According to an embodiment, the glass member 1022 may have a thickness of 20 micrometers to 150 micrometers, but the disclosure is not limited thereto. For example, the glass member 1022 may be 25 micrometers to 35 micrometers. The glass member 1022 may include ultra-thin glass (UTG) or polyimide (PI).

According to an embodiment, the first coating portion 1023-1 may be disposed to surround the lateral side 1022c of the glass member 1022. A portion of the first coating portion 1023-1 may be bonded to the lateral side 1022c of the glass member 1022. The first coating portion 1023-1 may be disposed to surround at least a portion of the surfaces of the glass member 1022 including the lateral side of the glass member 1022.

According to an embodiment, the refractive index of the first coating portion 1023-1 may be substantially the same as the refractive index of the glass member 1022. The first coating portion 1023-1 may be refractive index matched with the glass member 1022. By matching the refractive index of the first coating portion 1023-1 and the refractive index of the glass member 1022, the boundary surface between the first coating portion 1023-1 and the glass member 1022 may be inhibited from being visible from the outside. For example, the boundary surface formed on the lateral side 1022c of the glass member 1022, which extends about perpendicular to the front side of the flexible display 1000-1, may be inhibited from being visible from the outside through refractive index matching between the first coating portion 1023-1 and the glass member 1022.

According to an embodiment, the first coating portion 1023-1 and the second coating portion 1024-1 may have different modulus values. According to an embodiment, the first coating portion 1023-1 may have a relatively smaller modulus value than the second coating portion 1024-1. The first coating portion 1023-1 may have, e.g., relatively more flexible performance than the second coating portion 1024-1.

According to an embodiment, the first coating portion 1023-1 may be an elastic material. For example, the first coating portion 1023-1 may include acrylic, urethane, or silicone material, but the disclosure is not limited thereto. The glass assembly 1020-1 may secure bending durability by the elasticity of the first coating portion 1023-1. Bending durability may refer to performance that is not damaged even with repeated bending of the flexible display 1000-1. The first coating portion 1023-1 may be, e.g., optically clear resin (OCR). The first coating portion 1023-1 may be referred to as, e.g., a first coating layer or a first elastic coating layer.

According to an embodiment, the second coating portion 1024-1 may be disposed to surround the outer side of the first coating portion 1023-1. A portion of the second coating portion 1024-1 may be bonded or adhered to the outer side of the first coating portion 1023-1. For example, the second coating portion 1024-1 may be disposed to wrap the upper side and outer side of the first coating portion 1023-1.

According to an embodiment, the second coating portion 1024-1 may have a relatively larger modulus value than the first coating portion 1023-1. The second coating portion 1024-1 may have, e.g., relatively greater rigidity than the first coating portion 1023-1.

Adhesive force may be formed on the first coating portion 1023-1 having a relatively smaller modulus value. Due to this adhesive force, external foreign objects may adhere to the first coating portion 1023-1 and damage the glass assembly 1020-1. If the second coating portion 1024-1 wraps the outside of the first coating portion 1023-1, the first coating portion 1023-1 is spatially separated from the external air layer, reducing damage by foreign objects. For example, the second coating portion 1024-1 may have a modulus of 0.1 MPa or more.

According to an embodiment, as the second coating portion 1024-1 having a relatively larger modulus value wraps the outside of the first coating portion 1023-1, the second coating portion 1024-1 may constrain the deformation of the first coating portion 1023-1.

According to an embodiment, the second coating portion 1024-1 may be an elastic material. For example, the second coating portion 1024-1 may include acrylic, urethane, or silicone material, but the disclosure is not limited thereto. The glass assembly 1020-1 may secure bending durability by the elasticity of the second coating portion 1024-1. Bending durability may refer to performance that is not damaged even with repeated bending of the flexible display 1000-1. The second coating portion 1024-1 may be, e.g., optically clear resin (OCR). The second coating portion 1024-1 may be referred to as, e.g., a second coating layer or a second elastic coating layer.

According to an embodiment, the first coating portion 1023-1 and the second coating portion 1024-1 may be formed of a hyper elastic material. In the disclosure, by double coating the first coating portion 1023-1 and the second coating portion 1024-1 with different modulus values, wrinkle phenomena occurring in bent (rolled or folded) portions may be mitigated.

According to an embodiment, the outer side of the first coating portion 1023-1 may be disposed to vertically overlap the printed layer 1021. The outer side of the first coating portion 1023-1 may be disposed not to be visible from the outside by being hidden by the printed layer 1021. The outer side of the first coating portion 1023-1 is a boundary surface in contact with the inner side of the second coating portion 1024-1, and may be a surface substantially parallel to a direction perpendicular to the front side of the flexible display 1000-1. Since the first coating portion 1023-1 and the second coating portion 1024-1 have different roles and are configured with different modulus values, there may be a difference in refractive index between the first coating portion 1023-1 and the second coating portion 1024-1. Due to the difference in refractive index between the first coating portion 1023-1 and the second coating portion 1024-1, there is a problem that the outer side of the first coating portion 1023-1 is visible from the outside, degrading aesthetics. In the disclosure, by positioning the outer side of the first coating portion 1023-1 to vertically overlap the printed layer 1021, the boundary surface may be inhibited from being visible from the outside.

According to an embodiment, among the surfaces where the first coating portion 1023-1 and the second coating portion 1024-1 contact, a surface substantially perpendicular to the front side of the flexible display 1000-1 may be disposed to overlap the printed layer 1021. According to an embodiment, the printed layer 1021 may be disposed to overlap a surface substantially perpendicular to the front side of the flexible display 1000-1 among the surfaces where the first coating portion 1023-1 and the second coating portion 1024-1 contact. According to an embodiment, the printed layer 1021 may be disposed to be orthogonal to a virtual plane including a surface substantially perpendicular to the front side of the flexible display 1000-1 among the surfaces where the first coating portion 1023-1 and the second coating portion 1024-1 contact.

FIG. 9 is a cross-sectional view illustrating a glass assembly according to an embodiment.

The flexible display 1000-2 of FIG. 9 may be included or disposed in the electronic device (e.g., the electronic device 200 of FIG. 2A). The glass assembly 1020-2 of FIG. 9 may be included in the flexible display (e.g., the flexible display 1000 of FIG. 4) of FIGS. 4 and 5. However, the disclosure is not limited thereto.

Among the configurations illustrated in FIG. 9, the same reference numerals are used for configurations substantially the same or similar to the configurations of the flexible display 1000 of FIGS. 4 and 5.

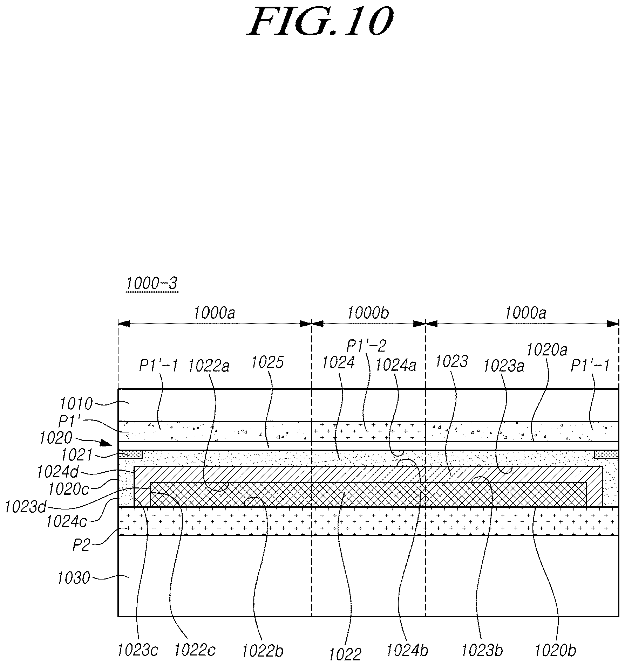

The embodiment of FIG. 9 may be selectively combined with the embodiments of FIGS. 5 to 8. The embodiment of FIG. 9 may be selectively combined with the embodiments of FIGS. 10 to 15C.

According to an embodiment, in the flexible display 1000-2, the glass assembly 1020 and the protective member 1010 may be sequentially stacked on the display panel 1030. The protective member 1010 may be stacked on the glass assembly 1020.

According to an embodiment, the glass assembly 1020 may include at least one of a printed layer 1021, a glass member 1022, a first coating portion 1023, or a second coating portion 1024-2. The glass assembly 1020 may include, e.g., a multi-stage format printed layer (e.g., the printed layer 1200 of FIG. 6) as illustrated in FIG. 6.

According to an embodiment, the glass member 1022 may include an upper side 1022a, a lower side1022b facing the opposite direction of the upper side 1022a, and a lateral side 1022c connecting the upper side 1022a and the lower side1022b. The lower side1022b of the glass member 1022 may form, e.g., a portion of the second surface 1020b of the glass assembly 1020, but the disclosure is not limited thereto.

At least a portion of the surfaces of the glass member 1022 may be wrapped by the first coating portion 1023. For example, a portion of the first coating portion 1023 may be attached or bonded to the lateral side 1022c of the glass member 1022. The first coating portion 1023 may be attached or bonded to the upper side 1022a of the glass member 1022 as illustrated. However, without limitations thereto, and may also be attached or bonded to the lower side1022b of the glass member 1022. The first coating portion 1023 may be disposed such that a portion thereof contacts at least one of the upper side 1022a or the lower side1022b of the glass member 1022.

According to an embodiment, the glass member 1022 may have a thickness of 20 micrometers to 150 micrometers, but the disclosure is not limited thereto. For example, the glass member 1022 may be 25 micrometers to 35 micrometers. The glass member 1022 may include ultra-thin glass (UTG) or polyimide (PI).

According to an embodiment, the first coating portion 1023 may be disposed to surround the lateral side 1022c of the glass member 1022. A portion of the first coating portion 1023 may be bonded to the lateral side 1022c of the glass member 1022. The first coating portion 1023 may be disposed to surround at least a portion of the surfaces of the glass member 1022 including the lateral side of the glass member 1022.

According to an embodiment, the refractive index of the first coating portion 1023 may be substantially the same as the refractive index of the glass member 1022. The first coating portion 1023 may be refractive index matched with the glass member 1022. By matching the refractive index of the first coating portion 1023 and the refractive index of the glass member 1022, the boundary surface between the first coating portion 1023 and the glass member 1022 may be inhibited from being visible from the outside. For example, the boundary surface formed on the lateral side 1022c of the glass member 1022, which extends about perpendicular to the front side of the flexible display 1000-2, may be inhibited from being visible from the outside through refractive index matching between the first coating portion 1023 and the glass member 1022.

According to an embodiment, the first coating portion 1023 and the second coating portion 1024-2 may have different modulus values. According to an embodiment, the first coating portion 1023 may have a relatively smaller modulus value than the second coating portion 1024-2. The first coating portion 1023 may have, e.g., relatively more flexible performance than the second coating portion 1024-2.

According to an embodiment, the second coating portion 1024-2 may be disposed to surround at least a portion of the surfaces of the glass member 1022 and the first coating portion 1023. A portion of the second coating portion 1024-2 may be bonded or adhered to the outer side of the first coating portion 1023. The second coating portion 1024-2 may be provided to wrap the entire outer sides of the glass member 1022 and the first coating portion 1023.

According to an embodiment, the second coating portion 1024-2 may have a relatively larger modulus value than the first coating portion 1023. The second coating portion 1024-2 may have, e.g., relatively greater rigidity than the first coating portion 1023. For example, the second coating portion 1024-2 may have a modulus of 0.1 MPa or more.

According to an embodiment, as the second coating portion 1024-2 having a relatively larger modulus value than the first coating portion 1023 wraps the outside of the glass member 1022 and the first coating portion 1023, the second coating portion 1024-2 may constrain the deformation of the first coating portion 1023 and protect the glass member 1022 from impacts applied from all directions.

According to an embodiment, the second coating portion 1024-2 may be an elastic material. For example, the second coating portion 1024-2 may include acrylic, urethane, or silicone material, but the disclosure is not limited thereto. The glass assembly 1020 may secure bending durability by the elasticity of the second coating portion 1024-2. Bending durability may refer to performance that is not damaged even with repeated bending of the flexible display 1000-2. The second coating portion 1024-2 may be, e.g., optically clear resin (OCR). The second coating portion 1024-2 may be referred to as, e.g., a second coating layer or a second elastic coating layer.

According to an embodiment, the first coating portion 1023 and the second coating portion 1024-2 may be formed of a hyper elastic material. In the disclosure, by double coating the first coating portion 1023 and the second coating portion 1024-2 with different modulus values, wrinkle phenomena occurring in bent (rolled or folded) portions may be mitigated.

Since the first coating portion 1023 and the second coating portion 1024-2 have different roles and are configured with different modulus values, there may be a difference in refractive index between the first coating portion 1023 and the second coating portion 1024-2. Due to the difference in refractive index between the first coating portion 1023 and the second coating portion 1024-2, there is a problem that the outer side of the first coating portion 1023 is visible from the outside, degrading aesthetics. In the disclosure, by positioning the outer side of the first coating portion 1023 to vertically overlap the printed layer 1021, the boundary surface may be inhibited from being visible from the outside.

According to an embodiment, among the surfaces where the first coating portion 1023 and the second coating portion 1024-2 contact, a surface substantially perpendicular to the front side of the flexible display 1000-2 may be disposed to overlap the printed layer 1021. According to an embodiment, the printed layer 1021 may be disposed to overlap a surface substantially perpendicular to the front side of the flexible display 1000-2 among the surfaces where the first coating portion 1023 and the second coating portion 1024-2 contact. According to an embodiment, the printed layer 1021 may be disposed to be orthogonal to a virtual plane including a surface substantially perpendicular to the front side of the flexible display 1000-2 among the surfaces where the first coating portion 1023 and the second coating portion 1024-2 contact.

FIG. 10 is a cross-sectional view illustrating a flexible display according to an embodiment.

The flexible display 1000-3 of FIG. 10 may be included in the electronic device (e.g., the electronic device 200 of FIG. 2A). However, the disclosure is not limited thereto.

Among the configurations illustrated in FIG. 10, the same reference numerals are used for configurations substantially the same or similar to the configurations of the flexible display (e.g., the flexible display 1000 of FIG. 4) of FIGS. 4 and 5. Duplicate descriptions are omitted below.

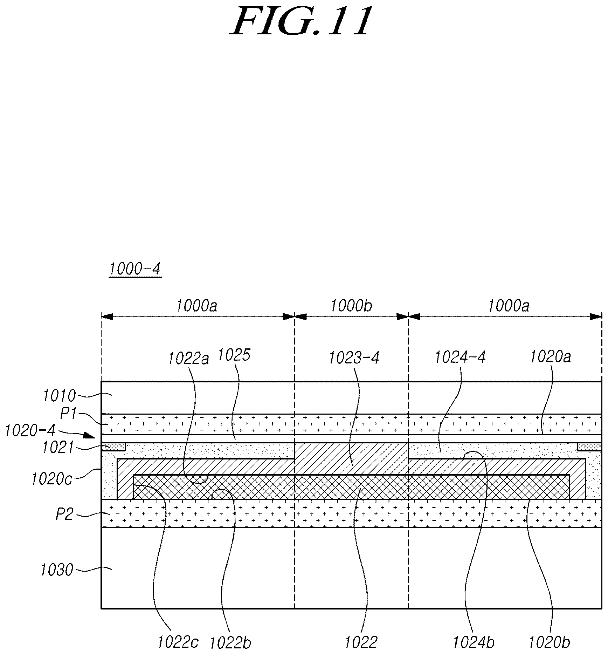

The embodiment of FIG. 10 may be selectively combined with the embodiments of FIGS. 5 to 9. The embodiment of FIG. 10 may be selectively combined with the embodiments of FIGS. 11 to 15C.

Referring to FIG. 10, the flexible display 1000-3 may include a non-flexible region 1000a and a flexible region 1000b. The flexible region 1000b may refer to a region mounted or included in the electronic device 200 and bent according to the operation of the electronic device 200. The non-flexible region 1000a may refer to a region other than the flexible region 1000b, maintaining a flat surface in case of being mounted on the electronic device 200.

According to an embodiment, in the flexible display 1000-3, the glass assembly 1020 and the protective member 1010 may be sequentially stacked on the display panel 1030. The protective member 1010 may be stacked on the glass assembly 1020.

According to an embodiment, the glass assembly 1020 may include at least one of a printed layer 1021, a glass member 1022, a first coating portion 1023, or a second coating portion 1024. The glass assembly 1020 may include, e.g., a multi-stage format printed layer (e.g., the printed layer 1200 of FIG. 6) as illustrated in FIG. 6.

According to an embodiment, the flexible display 1000-3 may include adhesive members P1', P2. The adhesive members P1', P2 may include at least one of an optically clear adhesive (OCA) film, an optically clear resin (OCR), a pressure sensitive adhesive (PSA) film, a heat-reactive adhesive, a general adhesive, or a double-sided tape. The adhesive members P1', P2 include a light-curing adhesive material or a thermosetting adhesive material, and the material thereof is not particularly limited. The adhesive members P1', P2 may include, e.g., at least one of a first adhesive member P1' provided to adhere the protective member 1010 and the glass assembly 1020, and a second adhesive member P2 provided to adhere the glass assembly 1020 and the display panel 1030. According to an embodiment, the first adhesive member P1' may be adhered to the first surface 1020b of the glass assembly 1020.

According to an embodiment, the first adhesive member P1' may include a 1-1th adhesive member P1'-1 and a 1-2th adhesive member P1'-2. The 1-1th adhesive member P1'-1 may be positioned in a portion corresponding to the non-flexible region 1000a of the flexible display 1000-3. The 1-2th adhesive member P1'-2 may be positioned in a portion corresponding to the flexible region 1000b of the flexible display 1000-3.

According to an example, the 1-1th adhesive member P1'-1 may have a relatively larger modulus value than the 1-2th adhesive member P1'-2. The 1-1th adhesive member P1'-1 may have, e.g., greater rigidity than the 1-2th adhesive member P1'-2. The 1-1th adhesive member P1'-1 having relatively high rigidity may enhance the impact resistance performance of the flexible display 1000-3 in the non-flexible region 1000a, and the 1-2th adhesive member P1'-2 having relatively high flexibility may enhance the bending durability of the flexible display 1000-3 in the flexible region 1000b.

FIG. 11 is a cross-sectional view illustrating a flexible display according to an embodiment.

The flexible display 1000-4 of FIG. 11 may be included in the electronic device (e.g., the electronic device 200 of FIG. 2A).

Among the configurations illustrated in FIG. 11, the same reference numerals are used for configurations substantially the same or similar to the configurations of the flexible display (e.g., the flexible display 1000 of FIG. 4) of FIGS. 4 and 5.

Referring to FIG. 11, the flexible display 1000-4 may include a non-flexible region 1000a and a flexible region 1000b. The flexible region 1000b may refer to a region mounted or included in the electronic device 200 and bent according to the operation of the electronic device 200. The non-flexible region 1000a may refer to a region other than the flexible region 1000b, maintaining a flat surface in case of being mounted on the electronic device 200.

According to an embodiment, in the flexible display 1000-4, the glass assembly 1020-4 and the protective member 1010 may be sequentially stacked on the display panel 1030. The protective member 1010 may be stacked on the glass assembly 1020-4.

According to an embodiment, the glass assembly 1020-4 may include at least one of a printed layer 1021, a glass member 1022, a first coating portion 1023-4, or a second coating portion 1024-4. The glass assembly 1020-4 may include, e.g., a multi-stage format printed layer (e.g., the printed layer 1200 of FIG. 6) as illustrated in FIG. 6.

According to an embodiment, the glass member 1022 may include an upper side 1022a, a lower side1022b facing the opposite direction of the upper side 1022a, and a lateral side 1022c connecting the upper side 1022a and the lower side1022b. The lower side1022b of the glass member 1022 may form, e.g., a portion of the second surface 1020b of the glass assembly 1020-4, but the disclosure is not limited thereto.

At least a portion of the surfaces of the glass member 1022 may be wrapped by the first coating portion 1023-4. For example, a portion of the first coating portion 1023-4 may be attached or bonded to the lateral side 1022c of the glass member 1022. The first coating portion 1023-4 may be attached or bonded to the upper side 1022a and the lower side1022b of the glass member 1022 as illustrated.

According to an embodiment, the first coating portion 1023-4 may be disposed to surround the lateral side 1022c of the glass member 1022. A portion of the first coating portion 1023-4 may be bonded to the lateral side 1022c of the glass member 1022. The first coating portion 1023-4 may be disposed to surround at least a portion of the surfaces of the glass member 1022 including the lateral side of the glass member 1022.

The first coating portion 1023-4 may be disposed such that a portion thereof contacts at least one of the upper side 1022a or the lower side1022b of the glass member 1022. A portion of the first coating portion 1023-4 may be bonded or attached to a portion of the upper side 1022a or the lower side1022b of the glass member 1022.

According to an embodiment, the refractive index of the first coating portion 1023-4 may be substantially the same as the refractive index of the glass member 1022. The first coating portion 1023-4 may be refractive index matched with the glass member 1022. By matching the refractive index of the first coating portion 1023-4 and the refractive index of the glass member 1022, the boundary surface between the first coating portion 1023-4 and the glass member 1022 may be inhibited from being visible from the outside. For example, the boundary surface formed on the lateral side 1022c of the glass member 1022, which extends about perpendicular to the front side of the flexible display 1000-4, may be inhibited from being visible from the outside through refractive index matching between the first coating portion 1023-4 and the glass member 1022.

According to an embodiment, the first coating portion 1023-4 and the second coating portion 1024-4 may have different modulus values. According to an embodiment, the first coating portion 1023-4 may have a relatively smaller modulus value than the second coating portion 1024-4. The first coating portion 1023-4 may have, e.g., relatively more flexible performance than the second coating portion 1024-4.

According to an embodiment, the first coating portion 1023-4 may be an elastic material. For example, the first coating portion 1023-4 may include acrylic, urethane, or silicone material, but the disclosure is not limited thereto. The glass assembly 1020-4 may secure bending durability by the elasticity of the first coating portion 1023-4. Bending durability may refer to performance that is not damaged even with repeated bending of the flexible display 1000-4. The first coating portion 1023-4 may be, e.g., optically clear resin (OCR). The first coating portion 1023-4 may be referred to as, e.g., a first coating layer or a first elastic coating layer.

According to an embodiment, the second coating portion 1024-4 may be disposed to surround the outer side of the first coating portion 1023-4. A portion of the second coating portion 1024-4 may be bonded or adhered to the outer side of the first coating portion 1023-4. For example, the second coating portion 1024-4 may be disposed to wrap the upper side and outer side of the first coating portion 1023-4.

According to an embodiment, the second coating portion 1024-4 may have a relatively larger modulus value than the first coating portion 1023-4. The second coating portion 1024-4 may have, e.g., relatively greater rigidity than the first coating portion 1023-4.

Adhesive force may be formed on the first coating portion 1023-4 having a relatively smaller modulus value than the second coating portion 1024-4. Due to this adhesive force, external foreign objects may adhere to the first coating portion 1023-4 and damage the glass assembly 1020-4. If the second coating portion 1024-4 wraps the outside of the first coating portion 1023-4, the first coating portion 1023-4 is spatially separated from the external air layer, reducing damage by foreign objects. For example, the second coating portion 1024-4 may have a modulus of 0.1 MPa or more.

According to an embodiment, as the second coating portion 1024-4 having a relatively larger modulus value than the first coating portion 1023-4 wraps the outside of the first coating portion 1023-4, the second coating portion 1024-4 may constrain the deformation of the first coating portion 1023-4.

According to an embodiment, the second coating portion 1024-4 may be an elastic material. For example, the second coating portion 1024-4 may include acrylic, urethane, or silicone material, but the disclosure is not limited thereto. The glass assembly 1020-4 may secure bending durability by the elasticity of the second coating portion 1024-4. Bending durability may refer to performance that is not damaged even with repeated bending of the flexible display 1000-4. The second coating portion 1024-4 may be, e.g., optically clear resin (OCR). The second coating portion 1024-4 may be referred to as, e.g., a second coating layer or a second elastic coating layer.

According to an embodiment, the first coating portion 1023-4 and the second coating portion 1024-4 may be formed of a hyper elastic material. In the disclosure, by double coating the first coating portion 1023-4 and the second coating portion 1024-4 with different modulus values, wrinkle phenomena occurring in bent (rolled or folded) portions may be mitigated.

According to an embodiment, the first coating portion 1023-4 and the second coating portion 1024-4 may be disposed or applied on the upper side 1022a of the glass member 1022. For example, the second coating portion 1024-4 may be disposed or applied on a portion corresponding to the non-flexible region 1000a on the upper side 1022a of the glass member 1022. For example, the first coating portion 1023-4 may be disposed on a portion corresponding to the flexible region 1000b on the upper side 1022a of the glass member 1022.

The second coating portion 1024-4, which has relatively higher impact resistance performance than the first coating portion 1023-4, is positioned in the non-flexible region 1000a to enhance the impact resistance performance of the flexible display 1000-4. The first coating portion 1023-4, which has higher flexibility than the second coating portion 1024-4, is positioned in the flexible region 1000b to enhance the bending durability of the flexible display 1000-4. As illustrated, by adjusting the proportion of the first coating portion 1023-4 and the second coating portion 1024-4 for the flexible region 1000b and the non-flexible region 1000a, the performance required for each region may be enhanced.

According to an embodiment, the outer side of the first coating portion 1023-4 may be disposed to vertically overlap the printed layer 1021. The outer side of the first coating portion 1023-4 may be disposed not to be visible from the outside by being hidden by the printed layer 1021. The outer side of the first coating portion 1023-4 is a boundary surface in contact with the inner side of the second coating portion 1024-4, and may be a surface substantially parallel to a direction perpendicular to the front side of the flexible display 1000-4. Since the first coating portion 1023-4 and the second coating portion 1024-4 have different roles and are configured with different modulus values, there may be a difference in refractive index between the first coating portion 1023-4 and the second coating portion 1024-4. Due to the difference in refractive index between the first coating portion 1023-4 and the second coating portion 1024-4, there is a problem that the outer side of the first coating portion 1023-4 is visible from the outside, degrading aesthetics. In the disclosure, by positioning the outer side of the first coating portion 1023-4 to vertically overlap the printed layer 1021, the boundary surface may be inhibited from being visible from the outside.

According to an embodiment, among the surfaces where the first coating portion 1023-4 and the second coating portion 1024-4 contact, a surface substantially perpendicular to the front side of the flexible display 1000-4 may be disposed to overlap the printed layer 1021. According to an embodiment, the printed layer 1021 may be disposed to overlap a surface substantially perpendicular to the front side of the flexible display 1000-4 among the surfaces where the first coating portion 1023-4 and the second coating portion 1024-4 contact. According to an embodiment, the printed layer 1021 may be disposed to be orthogonal to a virtual plane including a surface substantially perpendicular to the front side of the flexible display 1000-4 among the surfaces where the first coating portion 1023-4 and the second coating portion 1024-4 contact.

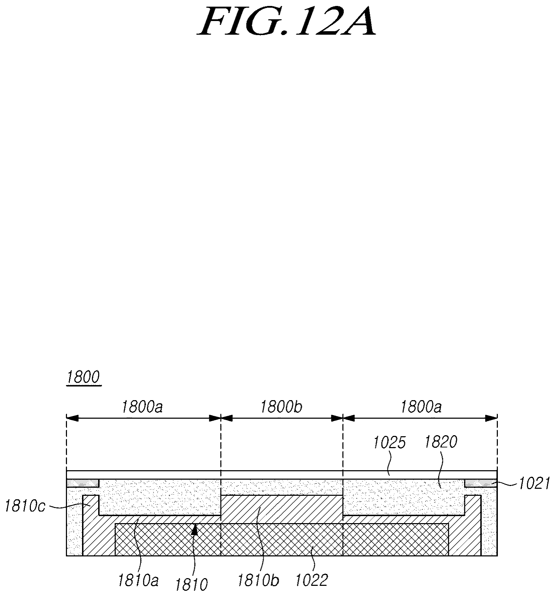

FIGS. 12A to 12C are cross-sectional views illustrating a glass assembly according to an embodiment.

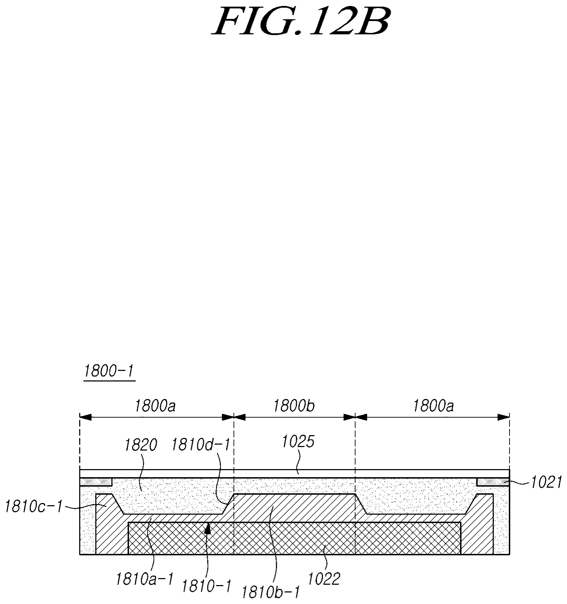

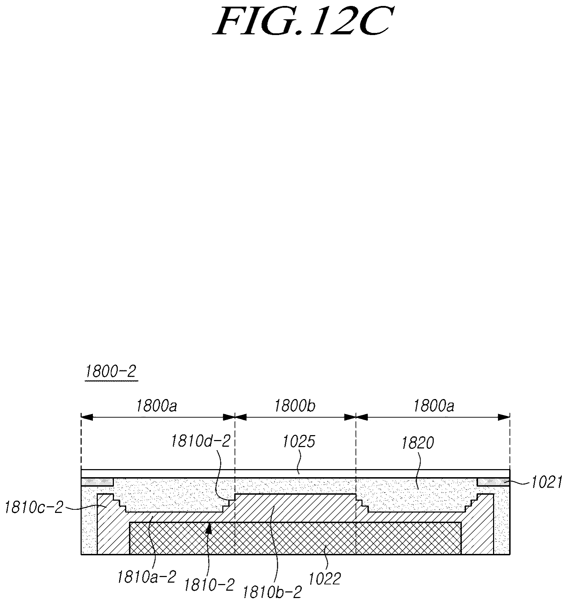

The glass assemblies 1800, 1800-1, 1800-2 of FIGS. 12A, 12B, or 12C may be included in the flexible display (e.g., the flexible display 1000 of FIG. 4) of FIGS. 4 and 5 or the electronic device (e.g., the electronic device 200 of FIG. 2A).

Among the configurations illustrated in FIGS. 12A, 12B, and 12C, the same reference numerals are used for configurations substantially the same or similar to the configurations of the glass assembly (e.g., the glass assembly 1020 of FIG. 4) of FIGS. 4 and 5.

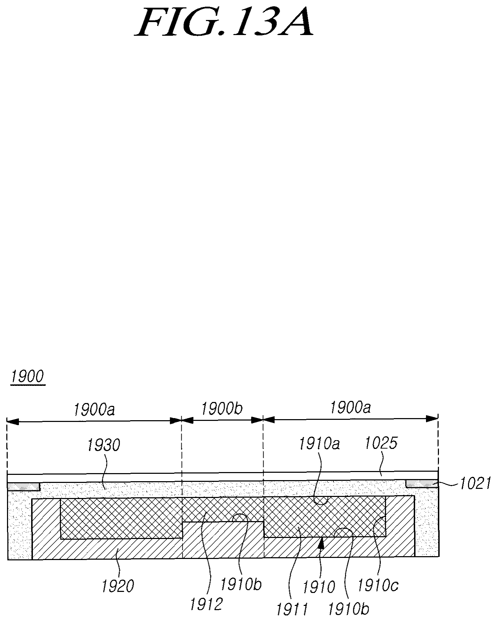

The embodiments of FIGS. 12A, 12B, or 12C may be selectively combined with the embodiments of FIGS. 5 to 11. The embodiments of FIGS. 12A, 12B, or 12C may be selectively combined with the embodiments of FIGS. 13A to 15C.

The glass assemblies 1800, 1800-1, 1800-2 may include a non-flexible region 1800a and a flexible region 1800b. The flexible region 1800b may refer to a region mounted or included in the electronic device 200 and bent according to the operation of the electronic device 200. The non-flexible region 1800a may refer to a region other than the flexible region 1800b, maintaining a flat surface in case of being mounted on the electronic device 200.

According to an embodiment, the glass assemblies 1800, 1800-1, 1800-2 may include at least one of a printed layer 1021, a glass member 1022, first coating portions 1810, 1810-1, 1810-2, or second coating portions 1820, 1820-1, 1820-2. The glass assemblies 1800, 1800-1, 1800-2 may include, e.g., a multi-stage format printed layer (e.g., the printed layer 1200 of FIG. 6) as illustrated in FIG. 6.

According to an embodiment, the first coating portions 1810, 1810-1, 1810-2 may be disposed to surround the lateral side of the glass member 1022. A portion of the first coating portions 1810, 1810-1, 1810-2 may be bonded to the lateral side of the glass member 1022. The first coating portions 1810, 1810-1, 1810-2 may be disposed to surround at least a portion of the surfaces of the glass member 1022 including the lateral side of the glass member 1022.

According to an example, the refractive index of the first coating portions 1810, 1810-1, 1810-2 may be substantially the same as the refractive index of the glass member 1022. The first coating portions 1810, 1810-1, 1810-2 may be refractive index matched with the glass member 1022. By matching the refractive index of the first coating portions 1810, 1810-1, 1810-2 and the refractive index of the glass member 1022, the boundary surface between the first coating portions 1810, 1810-1, 1810-2 and the glass member 1022 may be inhibited from being visible from the outside. For example, the boundary surface formed on the lateral side 1022c of the glass member 1022, which extends about perpendicular to the front side of the flexible display 1000, may be inhibited from being visible from the outside through refractive index matching between the first coating portions 1810, 1810-1, 1810-2 and the glass member 1022.

According to an example, the first coating portions 1810, 1810-1, 1810-2 and the second coating portions 1820, 1820-1, 1820-2 may have different modulus values. According to an example, the first coating portions 1810, 1810-1, 1810-2 may have a relatively smaller modulus value than the second coating portions 1820, 1820-1, 1820-2. The first coating portions 1810, 1810-1, 1810-2 may have, e.g., relatively more flexible performance than the second coating portions 1820, 1820-1, 1820-2.

According to an example, the first coating portions 1810, 1810-1, 1810-2 may be an elastic material. For example, the first coating portions 1810, 1810-1, 1810-2 may include acrylic, urethane, or silicone material, but the disclosure is not limited thereto. The glass assemblies 1800, 1800-1, 1800-2 may secure bending durability by the elasticity of the first coating portions 1810, 1810-1, 1810-2. Bending durability may refer to performance that is not damaged even with repeated bending of the flexible display 1000. The first coating portions 1810, 1810-1, 1810-2 may be, e.g., optically clear resin (OCR). The first coating portions 1810, 1810-1, 1810-2 may be referred to as, e.g., a first coating layer or a first elastic coating layer.

According to an example, the second coating portions 1820, 1820-1, 1820-2 may be disposed to surround the outer side of the first coating portions 1810, 1810-1, 1810-2. A portion of the second coating portions 1820, 1820-1, 1820-2 may be bonded to the outer side of the first coating portions 1810, 1810-1, 1810-2. The second coating portions 1820, 1820-1, 1820-2 may be disposed to surround at least a portion of the surfaces of the first coating portions 1810, 1810-1, 1810-2 including the outer side of the first coating portions 1810, 1810-1, 1810-2.

According to an example, the second coating portions 1820, 1820-1, 1820-2 may have a relatively larger modulus value than the first coating portions 1810, 1810-1, 1810-2. The second coating portions 1820, 1820-1, 1820-2 may have, e.g., relatively greater rigidity than the first coating portions 1810, 1810-1, 1810-2. The second coating portions 1820, 1820-1, 1820-2 may protect the first coating portions 1810, 1810-1, 1810-2 and the glass member 1022 disposed within the second coating portions 1820, 1820-1, 1820-2 from external impacts.

Adhesive force may be formed on the first coating portions 1810, 1810-1, 1810-2 having a relatively smaller modulus value. Due to this adhesive force, external foreign objects may adhere to the first coating portions 1810, 1810-1, 1810-2 and damage the glass assemblies 1800, 1800-1, 1800-2. If the second coating portions 1820, 1820-1, 1820-2 wrap the outside of the first coating portions 1810, 1810-1, 1810-2, the first coating portions 1810, 1810-1, 1810-2 are spatially separated from the external air layer, reducing damage by foreign objects. For example, the second coating portions 1820, 1820-1, 1820-2 may have a modulus of 0.1 MPa or more.

According to an example, as the second coating portions 1820, 1820-1, 1820-2 having a relatively larger modulus value wraps the outside of the first coating portions 1810, 1810-1, 1810-2, the second coating portions 1820, 1820-1, 1820-2 may constrain the deformation of the first coating portions 1810, 1810-1, 1810-2.

According to an example, the first coating portions 1820, 1820-2, 1820-2 may be an elastic material. For example, the first coating portions 1820, 1820-2, 1820-2 may include acrylic, urethane, or silicone material, but the disclosure is not limited thereto. The glass assemblies 1800, 1800-1, 1800-2 may secure bending durability by the elasticity of the second coating portions 1820, 1820-1, 1820-2. Bending durability may refer to performance that is not damaged even with repeated bending of the flexible display 1000. The first coating portions 1820, 1820-2, 1820-2 may be, e.g., optically clear resin (OCR). The second coating portions 1820, 1820-1, 1820-2 may be referred to as, e.g., a second coating layer or a second elastic coating layer.

According to an example, among the surfaces where the first coating portions 1810, 1810-1, 1810-2 and the second coating portions 1820, 1820-1, 1820-2 contact, a surface substantially perpendicular to the front side of the flexible display (e.g., the flexible display 1000 of FIG. 10) may be disposed to overlap the printed layer 1021. According to an example, the printed layer 1021 may be disposed to overlap a surface substantially perpendicular to the front side of the flexible display 1000 among the surfaces where the first coating portions 1810, 1810-1, 1810-2 and the second coating portions 1820, 1820-1, 1820-2 contact. According to an example, the printed layer 1021 may be disposed to be orthogonal to a virtual plane including a surface substantially perpendicular to the front side of the flexible display 1000 among the surfaces where the first coating portions 1810, 1810-1, 1810-2 and the second coating portions 1820, 1820-1, 1820-2 contact.

According to an example, the first coating portions 1810, 1810-1, 1810-2 and the second coating portions 1820, 1820-1, 1820-2 may be formed of a hyper elastic material. In the disclosure, by double coating the first coating portions 1810, 1810-1, 1810-2 and the second coating portions 1820, 1820-1, 1820-2 with different modulus values, wrinkle phenomena occurring in bent (rolled or folded) portions may be mitigated.

Referring to FIGS. 12A, 12B, and 12C, the first coating portions 1810, 1810-1, 1810-2 may include 1-1th coating portions 1810a, 1810a-1, 1810a-2 and 1-3th coating portions 1810c, 1810c-1, 1810c-2 corresponding to the non-flexible region 1800a. The first coating portions 1810, 1810-1, 1810-2 may include 1-2th coating portions 1810b, 1810b-1, 1810b-2 corresponding to the flexible region 1800b. The 1-1th coating portions 1810a, 1810a-1, 1810a-2 and the 1-2th coating portions 1810b, 1810b-1, 1810b-2 may have different thicknesses. For example, the thickness of the 1-1th coating portions 1810a, 1810a-1, 1810a-2 may be smaller than the thickness of the 1-2th coating portions 1810b, 1810b-1, 1810b-2. Here, the thickness may refer to an average thickness. For example, the proportion of the 1-1th coating portions 1810a, 1810a-1, 1810a-2 in the non-flexible region 1800a of the glass assemblies 1800, 1800-1, 1800-2 may be smaller than the proportion of the 1-2th coating portions 1810b, 1810b-1, 1810b-2 in the flexible region 1800b of the glass assemblies 1800, 1800-2, 1800-2. By increasing the proportion of the first coating portions 1810, 1810-1, 1810-2 having a relatively small modulus value in the flexible region 1800b, bending durability may be secured. According to an embodiment, the 1-3th coating portions 1810c, 1810c-1, 1810c-2 may be positioned below the printed layer 1021.

Referring to FIG. 12A, a step may be formed between the 1-1th coating portion 1810a and the 1-2th coating portion 1810b. A step may be formed between the 1-1th coating portion 1810a and the 1-3th coating portion 1810c.

Referring to FIG. 12B, an inclined surface 1810d-1 may be formed between the 1-1th coating portion 1810a-1 and the 1-2th coating portion 1810b-1. In the case of a vertical step, bubbles may be generated near the step in case of applying the second coating portion 1820 on the first coating portion 1810-1, so bubbles may be reduced by forming the inclined surface 1810d-1.

Referring to FIG. 12C, a stepped surface 1810d-2 may be formed between the 1-1th coating portion 1810a-2 and the 1-2th coating portion 1810b-2. In the case of a vertical step, bubbles may be generated near the step in case of applying the second coating portion 1820 on the first coating portion 1810-2, so bubbles may be reduced by forming the stepped surface 1810d-2.

FIGS. 13A to 13C are cross-sectional views illustrating a glass assembly according to an embodiment.

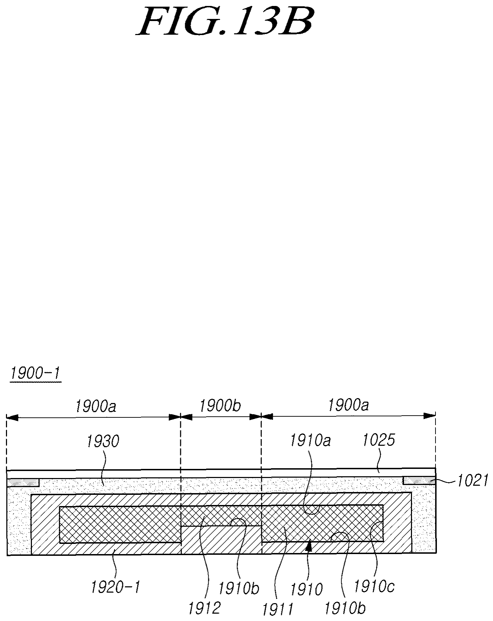

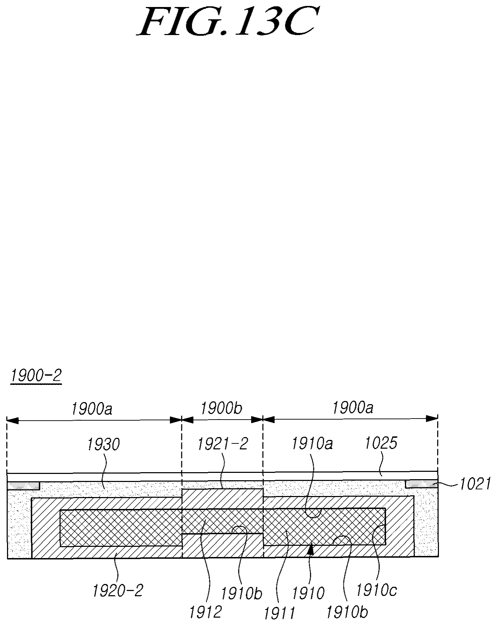

The glass assemblies 1900, 1900-1, 1900-2 of FIG. 13A, 13B, or 13C may be included in the flexible display (e.g., the flexible display 1000 of FIG. 4) of FIGS. 4 and 5 or the electronic device (e.g., the electronic device 200 of FIG. 2A).

Among the configurations illustrated in FIG. 13A, 13B, or 13C, the same reference numerals are used for configurations substantially the same or similar to the configurations of the glass assembly (e.g., the glass assembly 1020 of FIG. 4) of FIGS. 4 and 5.

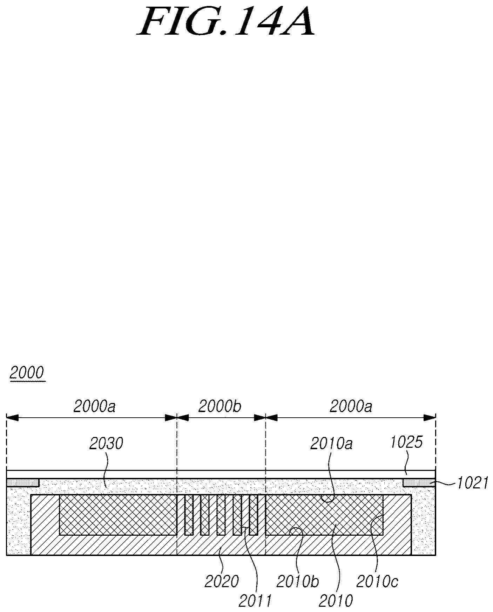

The embodiments of FIG. 13A, 13B, or 13C may be selectively combined with the embodiments of FIGS. 5 to 12C. The embodiments of FIG. 13A, 13B, or 13C may be selectively combined with the embodiments of FIGS. 14A to 15C.

The glass assemblies 1900, 1900-1, 1900-2 may include a non-flexible region 1900a and a flexible region 1900b. The flexible region 1900b may refer to a region mounted or included in the electronic device 200 and bent according to the operation of the electronic device 200. The non-flexible region 1900a may refer to a region other than the flexible region 1900b, maintaining a flat surface in case of being mounted on the electronic device 200.

According to an embodiment, the glass assemblies 1900, 1900-1, 1900-2 may include at least one of a printed layer 1021, a glass member 1910, first coating portions 1920, 1920-1, 1920-2, or a second coating portion 1930. The glass assemblies 1900, 1900-1, 1900-2 may include, e.g., a multi-stage format printed layer (e.g., the printed layer 1200 of FIG. 6) as illustrated in FIG. 6.

According to an embodiment, the glass member 1910 may include an upper side 1910a, a lower side1910b facing the opposite direction of the upper side 1910a, and a lateral side 1910c connecting the upper side 1910a and the lower side1910b.

According to an embodiment, the glass member 1910 may have a thickness of 20 micrometers to 150 micrometers, but the disclosure is not limited thereto. For example, the glass member 1910 may be 25 micrometers to 35 micrometers. The glass member 1910 may include ultra-thin glass (UTG) or polyimide (PI).

According to an embodiment, the glass member 1910 may have a differential thickness structure. The thickness of a first portion 1911 corresponding to the non-flexible region 1900a in the glass member 1910 may be thicker than the thickness of a second portion 1912 corresponding to the flexible region 1900b. By providing a thin glass member 1910 in portions requiring bending, the bending performance of the glass assemblies 1900, 1900-1, 1900-2 may be enhanced. By forming the glass member 1910 relatively thick in the non-flexible region 1900a that does not require bending, the impact resistance performance for the non-flexible region 1900a may be enhanced.

According to an example, the first coating portions 1920, 1920-1, 1920-2 may be disposed to surround the lateral side 1910c of the glass member 1910. A portion of the first coating portions 1920, 1920-1, 1920-2 may be bonded to the lateral side 1910c of the glass member 1910. The first coating portions 1920, 1920-1, 1920-2 may be disposed to surround at least a portion of the surfaces of the glass member 1910 including the lateral side of the glass member 1910.

The first coating portions 1920, 1920-1, 1920-2 may be disposed such that a portion thereof contacts at least one of the upper side 1910a or the lower side1910b of the glass member 1910. A portion of the first coating portions 1920, 1920-1, 1920-2 may be bonded or attached to the upper side 1910a or the lower side1910b of the glass member 1910. For example, the first coating portions 1920, 1920-1, 1920-2 may be disposed to wrap the lateral side 1910c and the upper side 1910a of the glass member 1910.

According to an example, the refractive index of the first coating portions 1920, 1920-1, 1920-2 may be substantially the same as the refractive index of the glass member 1910. The first coating portions 1920, 1920-1, 1920-2 may be refractive index matched with the glass member 1910. By matching the refractive index of the first coating portions 1920, 1920-1, 1920-2 and the refractive index of the glass member 1910, the boundary surface between the first coating portions 1920, 1920-1, 1920-2 and the glass member 1910 may be inhibited from being visible from the outside. For example, the boundary surface formed on the lateral side 1910c of the glass member 1910, which extends about perpendicular to the front side of the flexible display 1000, may be inhibited from being visible from the outside through refractive index matching between the first coating portions 1920, 1920-1, 1920-2 and the glass member 1910.

According to an example, the first coating portions 1920, 1920-1, 1920-2 and the second coating portion 1930 may have different modulus values. According to an example, the first coating portions 1920, 1920-1, 1920-2 may have a relatively smaller modulus value than the second coating portion 1930. The first coating portions 1920, 1920-1, 1920-2 may have, e.g., relatively more flexible performance than the second coating portion 1930.

According to an example, the first coating portions 1920, 1920-1, 1920-2 may be an elastic material. For example, the first coating portions 1920, 1920-1, 1920-2 may include acrylic, urethane, or silicone material, but the disclosure is not limited thereto. The glass assemblies 1900, 1900-1, 1900-2 may secure bending durability by the elasticity of the first coating portions 1920, 1920-1, 1920-2. Bending durability may refer to performance that is not damaged even with repeated bending of the flexible display 1000. The first coating portions 1920, 1920-1, 1920-2 may be, e.g., optically clear resin (OCR). The first coating portions 1920, 1920-1, 1920-2 may be referred to as, e.g., a first coating layer or a first elastic coating layer.

According to an example, the second coating portion 1930 may be disposed to surround the outer side of the first coating portions 1920, 1920-1, 1920-2. A portion of the second coating portion 1930 may be bonded to the outer side of the first coating portions 1920, 1920-1, 1920-2. The second coating portion 1930 may be disposed to surround at least a portion of the surfaces of the first coating portions 1920, 1920-1, 1920-2 including the outer side of the first coating portions 1920, 1920-1, 1920-2.

According to an example, the second coating portion 1930 may have a relatively larger modulus value than the first coating portions 1920, 1920-1, 1920-2. The second coating portion 1930 may have, e.g., relatively greater rigidity than the first coating portions 1920, 1920-1, 1920-2. The second coating portion 1930 may protect the first coating portions 1920, 1920-1, 1920-2 and the glass member 1910 disposed within the second coating portion 1930 from external impacts.

Adhesive force may be formed on the first coating portions 1920, 1920-1, 1920-2 having a relatively smaller modulus value. Due to this adhesive force, external foreign objects may adhere to the first coating portions 1920, 1920-1, 1920-2 and damage the glass assemblies 1900, 1900-1, 1900-2. If the second coating portion 1930 wraps the outside of the first coating portions 1920, 1920-1, 1920-2, the first coating portions 1920, 1920-1, 1920-2 are spatially separated from the external air layer, reducing damage by foreign objects. For example, the second coating portion 1930 may have a modulus of 0.1 MPa or more.

According to an example, as the second coating portion 1930 having a relatively larger modulus value wraps the outside of the first coating portions 1920, 1920-1, 1920-2, the second coating portion 1930 may constrain the deformation of the first coating portions 1920, 1920-1, 1920-2.

According to an example, the second coating portion 1930 may be an elastic material. For example, the second coating portion 1930 may include acrylic, urethane, or silicone material, but the disclosure is not limited thereto. The glass assemblies 1900, 1900-1, 1900-2 may secure bending durability by the elasticity of the second coating portion 1930. Bending durability may refer to performance that is not damaged even with repeated bending of the flexible display 1000. The second coating portion 1930 may be, e.g., optically clear resin (OCR). The second coating portion 1930 may be referred to as, e.g., a second coating layer or a second elastic coating layer.

According to an example, among the surfaces where the first coating portions 1920, 1920-1, 1920-2 and the second coating portion 1930 contact, a surface substantially perpendicular to the front side of the flexible display (e.g., the flexible display 1000 of FIG. 10) may be disposed to overlap the printed layer 1021. According to an example, the printed layer 1021 may be disposed to overlap a surface substantially perpendicular to the front side of the flexible display 1000 among the surfaces where the first coating portions 1920, 1920-1, 1920-2 and the second coating portion 1930 contact. According to an example, the printed layer 1021 may be disposed to be orthogonal to a virtual plane including a surface substantially perpendicular to the front side of the flexible display 1000 among the surfaces where the first coating portions 1920, 1920-1, 1920-2 and the second coating portion 1930 contact.

According to an embodiment, the first coating portions 1920, 1920-1, 1920-2 and the second coating portion 1930 may be formed of a hyper elastic material. In the disclosure, by double coating the first coating portions 1920, 1920-1, 1920-2 and the second coating portion 1930 with different modulus values, wrinkle phenomena occurring in bent (rolled or folded) portions may be mitigated.

Referring to FIG. 13A, the first coating portion 1920 may be disposed to contact the lateral side 1910c and the lower side1910b of the glass member 1910.

Referring to FIG. 13B, the first coating portion 1920-1 may be disposed to wrap the entire surface (the upper side 1910a, the lower side1910b, and the lateral side 1910c) of the glass member 1910. The first coating portion 1920-1 may be disposed to entirely wrap the surface of the glass member 1910.

Referring to FIG. 13C, the first coating portion 1920-2 may be disposed to wrap the entire surface (the upper side 1910a, the lower side1910b, and the lateral side 1910c) of the glass member 1910. As compared with the embodiment of FIG. 13B, the first coating portion 1920-2 may protrude more upward in the flexible region 1900b of the glass assembly 1900-2. By increasing the proportion of the first coating portion 1920-2 in the flexible region 1900b, bending performance may be enhanced.

FIGS. 14A to 14C are cross-sectional views illustrating a glass assembly according to an embodiment.

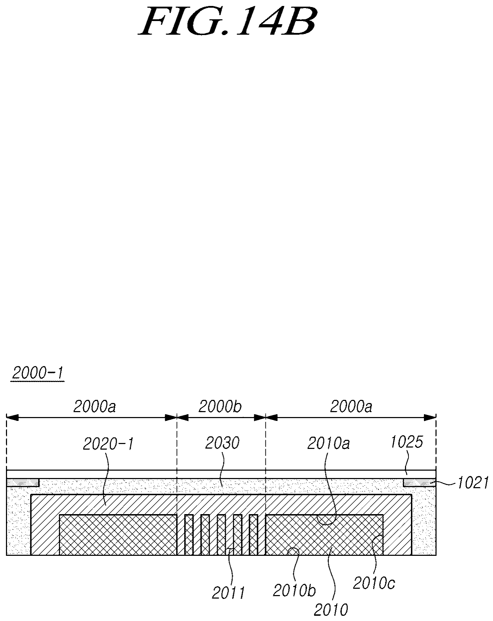

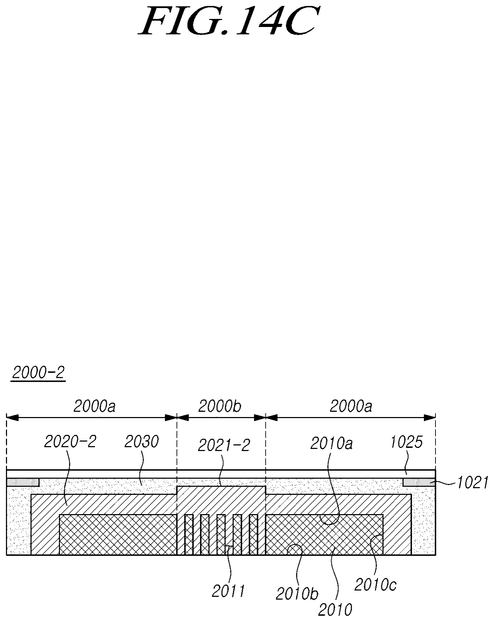

The glass assemblies 2000, 2000-1, 2000-2 of FIGS. 14A, 14B, or 14C may be included in the flexible display 1000 of FIGS. 4 and 5 or the electronic device 200 of FIG. 2A. However, the disclosure is not limited thereto. The structures of the glass assemblies 2000, 2000-1, 2000-2 illustrated in FIGS. 14A, 14B, or 14C are exemplary, and may be included or disposed in the electronic device 400 of FIG. 4A, the electronic device 600 of FIG. 6, or the electronic device 800 of FIG. 8 by varying the arrangement of the flexible region and the non-flexible region.

The glass assemblies 2000, 2000-1, 2000-2 illustrated in FIGS. 14A, 14B, or 14C may be substantially the same or similar to the glass assembly (e.g., the glass assembly 1020 of FIG. 4) provided in the flexible display (e.g., the flexible display 1000 of FIG. 4) of FIGS. 4 and 5 described above. The glass assemblies 2000, 2000-1, 2000-2 of FIGS. 14A, 14B, or 14C may be included in the flexible display 1000 of FIGS. 4 and 5 or the electronic device 200 of FIG. 2A. However, the disclosure is not limited thereto.

Among the configurations illustrated in FIGS. 14A, 14B, or 14C, the same reference numerals are used for configurations substantially the same or similar to the configurations of the glass assembly (e.g., the glass assembly 1020 of FIG. 4) of FIGS. 4 and 5.

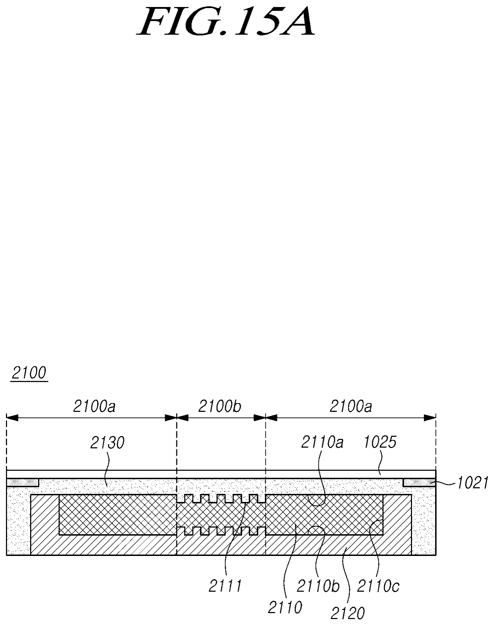

The embodiments of FIGS. 14A, 14B, or 14C may be selectively combined with the embodiments of FIGS. 5 to 13C. The embodiments of FIGS. 14A, 14B, or 14C may be selectively combined with the embodiments of FIGS. 15A to 15C.

The glass assemblies 2000, 2000-1, 2000-2 may include a non-flexible region 2000a and a flexible region 2000b. The flexible region 2000b may refer to a region mounted or included in the electronic device 200 and bent according to the operation of the electronic device 200. The non-flexible region 2000a may refer to a region other than the flexible region 2000b, maintaining a flat surface in case of being mounted on the electronic device 200.

According to an embodiment, the glass assemblies 2000, 2000-1, 2000-2 may include at least one of a printed layer 1021, a glass member 2010, first coating portions 2020, 2020-1, 2020-2, or a second coating portion 2030. The glass assemblies 2000, 2000-1, 2000-2 may include, e.g., a multi-stage format printed layer (e.g., the printed layer 1200 of FIG. 6) as illustrated in FIG. 6.

According to an embodiment, the glass member 2010 may include an upper side 2010a, a lower side2010b facing the opposite direction of the upper side 2010a, and a lateral side 2010c connecting the upper side 2010a and the lower side2010b.

According to an embodiment, the glass member 2010 may have a thickness of 20 micrometers to 150 micrometers, but the disclosure is not limited thereto. For example, the glass member 2010 may be 25 micrometers to 35 micrometers. The glass member 2010 may include ultra-thin glass (UTG) or polyimide (PI).

According to an embodiment, the glass member 2010 may include a plurality of through holes or slits 2011. The plurality of through holes or slits 2011 may be disposed in a portion corresponding to the flexible region 2000b in the glass member 2010. By forming the plurality of through holes or slits 2011 in the flexible region 2000b, the glass member 2010 may be bent more flexibly.

According to an example, the first coating portions 2020, 2020-1, 2020-2 may be disposed to surround the lateral side 2010c of the glass member 2010. A portion of the first coating portions 2020, 2020-1, 2020-2 may be bonded to the lateral side 2010c of the glass member 2010. The first coating portions 2020, 2020-1, 2020-2 may be disposed to surround at least a portion of the surfaces of the glass member 2010 including the lateral side of the glass member 2010.

The first coating portions 2020, 2020-1, 2020-2 may be disposed such that a portion thereof contacts at least one of the upper side 2010a or the lower side2010b of the glass member 2010. A portion of the first coating portions 2020, 2020-1, 2020-2 may be bonded or attached to the upper side 2010a or the lower side2010b of the glass member 2010. For example, the first coating portions 2020, 2020-1, 2020-2 may be disposed to wrap the lateral side 2010c and the upper side 2010a of the glass member 2010.

According to an example, a portion of the first coating portions 2020, 2020-1, 2020-2 may be filled within the plurality of through holes or slits 2011 of the glass member 2010.

According to an example, the refractive index of the first coating portions 2020, 2020-1, 2020-2 may be substantially the same as the refractive index of the glass member 2010. The first coating portions 2020, 2020-1, 2020-2 may be refractive index matched with the glass member 2010. By matching the refractive index of the first coating portions 2020, 2020-1, 2020-2 and the refractive index of the glass member 2010, the boundary surface between the first coating portions 2020, 2020-1, 2020-2 and the glass member 2010 may be inhibited from being visible from the outside. For example, the boundary surface formed on the lateral side 2010c of the glass member 2010, which extends about perpendicular to the front side of the flexible display 1000, may be inhibited from being visible from the outside through refractive index matching between the first coating portions 2020, 2020-1, 2020-2 and the glass member 2010.

According to an example, the first coating portions 2020, 2020-1, 2020-2 and the second coating portion 2030 may have different modulus values. According to an example, the first coating portions 2020, 2020-1, 2020-2 may have a relatively smaller modulus value than the second coating portion 2030. The first coating portions 2020, 2020-1, 2020-2 may have, e.g., relatively more flexible performance than the second coating portion 2030.

According to an example, the first coating portions 2020, 2020-1, 2020-2 may be an elastic material. For example, the first coating portions 2020, 2020-1, 2020-2 may include acrylic, urethane, or silicone material, but the disclosure is not limited thereto. The glass assemblies 2000, 2000-1, 2000-2 may secure bending durability by the elasticity of the first coating portions 2020, 2020-1, 2020-2. Bending durability may refer to performance that is not damaged even with repeated bending of the flexible display 1000. The first coating portions 2020, 2020-1, 2020-2 may be, e.g., optically clear resin (OCR). The first coating portions 2020, 2020-1, 2020-2 may be referred to as, e.g., a first coating layer or a first elastic coating layer.

According to an example, the second coating portion 2030 may be disposed to surround the outer side of the first coating portions 2020, 2020-1, 2020-2. A portion of the second coating portion 2030 may be bonded to the outer side of the first coating portions 2020, 2020-1, 2020-2. The second coating portion 2030 may be disposed to surround at least a portion of the surfaces of the first coating portions 2020, 2020-1, 2020-2 including the outer side of the first coating portions 2020, 2020-1, 2020-2.

According to an example, the second coating portion 2030 may have a relatively larger modulus value than the first coating portions 2020, 2020-1, 2020-2. The second coating portion 2030 may have, e.g., relatively greater rigidity than the first coating portions 2020, 2020-1, 2020-2. The second coating portion 2030 may protect the first coating portions 2020, 2020-1, 2020-2 and the glass member 2010 disposed within the second coating portion 2030 from external impacts.

Adhesive force may be formed on the first coating portions 2020, 2020-1, 2020-2 having a relatively smaller modulus value. Due to this adhesive force, external foreign objects may adhere to the first coating portions 2020, 2020-1, 2020-2 and damage the glass assemblies 2000, 2000-1, 2000-2. If the second coating portion 2030 wraps the outside of the first coating portions 2020, 2020-1, 2020-2, the first coating portions 2020, 2020-1, 2020-2 are spatially separated from the external air layer, reducing damage by foreign objects. For example, the second coating portion 2030 may have a modulus of 0.1 MPa or more.

According to an example, as the second coating portion 2030 having a relatively larger modulus value wraps the outside of the first coating portions 2020, 2020-1, 2020-2, the second coating portion 2030 may constrain the deformation of the first coating portions 2020, 2020-1, 2020-2.

According to an example, the second coating portion 2030 may be an elastic material. For example, the second coating portion 2030 may include acrylic, urethane, or silicone material, but the disclosure is not limited thereto. The glass assemblies 2000, 2000-1, 2000-2 may secure bending durability by the elasticity of the second coating portion 2030. Bending durability may refer to performance that is not damaged even with repeated bending of the flexible display 1000. The second coating portion 2030 may be, e.g., optically clear resin (OCR). The second coating portion 2030 may be referred to as, e.g., a second coating layer or a second elastic coating layer.

According to an example, among the surfaces where the first coating portions 2020, 2020-1, 2020-2 and the second coating portion 2030 contact, a surface substantially perpendicular to the front side of the flexible display (e.g., the flexible display 1000 of FIG. 10) may be disposed to overlap the printed layer 1021. According to an example, the printed layer 1021 may be disposed to overlap a surface substantially perpendicular to the front side of the flexible display 1000 among the surfaces where the first coating portions 2020, 2020-1, 2020-2 and the second coating portion 2030 contact. According to an example, the printed layer 1021 may be disposed to be orthogonal to a virtual plane including a surface substantially perpendicular to the front side of the flexible display 1000 among the surfaces where the first coating portions 2020, 2020-1, 2020-2 and the second coating portion 2030 contact.

According to an example, the first coating portions 2020, 2020-1, 2020-2 and the second coating portion 2030 may be formed of a hyper elastic material. In the disclosure, by double coating the first coating portions 2020, 2020-1, 2020-2 and the second coating portion 2030 with different modulus values, wrinkle phenomena occurring in bent (rolled or folded) portions may be mitigated.

Referring to FIG. 14A, the first coating portion 2020 may be disposed to contact the lateral side 1910c and the lower side1910b of the glass member 2010.

Referring to FIG. 14B, the first coating portion 2020-1 may be disposed to wrap the entire surface (the upper side 2010a, the lower side2010b, and the lateral side 2010c) of the glass member 2010. The first coating portion 2020-1 may be disposed to entirely wrap the surface of the glass member 2010.

Referring to FIG. 14C, the first coating portion 2020-2 may be disposed to wrap the entire surface (the upper side 2010a, the lower side2010b, and the lateral side 2010c) of the glass member 2010. As compared with the embodiment of FIG. 14B, the first coating portion 2020-2 may protrude more upward in the flexible region 2000b of the glass assembly 2000-2. By increasing the proportion of the first coating portion 2020-2 in the flexible region 2000b, bending performance may be enhanced.

FIGS. 15A to 15C are cross-sectional views illustrating a glass assembly according to an embodiment.

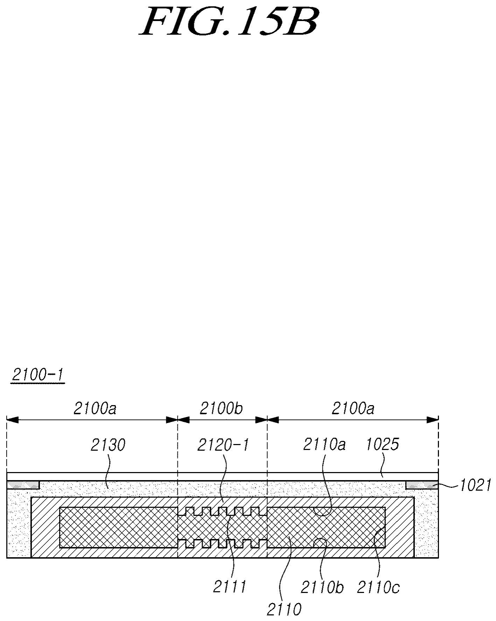

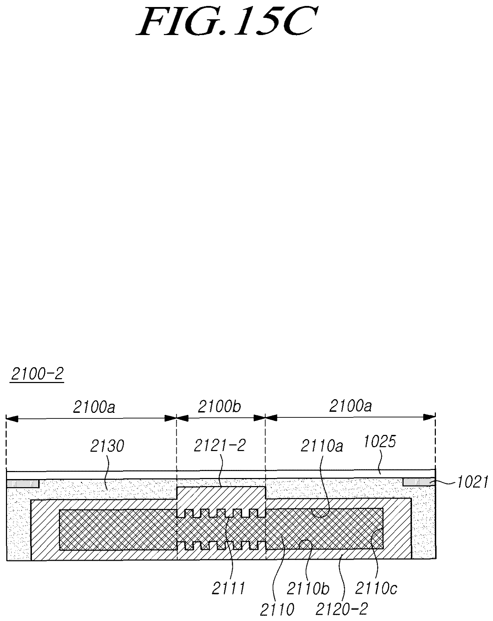

The glass assemblies 2100, 2100-1, 2100-2 of FIGS. 15A, 15B, or 15C may be included in the flexible display (e.g., the flexible display 1000 of FIG. 4) of FIGS. 4 and 5 or the electronic device (e.g., the electronic device 200 of FIG. 2A).

Among the configurations illustrated in FIGS. 15A, 15B, or 15C, the same reference numerals are used for configurations substantially the same or similar to the configurations of the glass assembly (e.g., the glass assembly 1020 of FIG. 4) of FIGS. 4 and 5.

The embodiments of FIGS. 15A, 15B, or 15C may be selectively combined with the embodiments of FIGS. 5 to 14C.

According to an embodiment, the glass assemblies 2100, 2100-1, 2100-2 may include a non-flexible region 2100a and a flexible region 2100b. The flexible region 2100b may refer to a region mounted or included in the electronic device 200 and bent according to the operation of the electronic device 200. The non-flexible region 2100a may refer to a region other than the flexible region 2100b, maintaining a flat surface in case of being mounted on the electronic device 200.

According to an embodiment, the glass assemblies 2100, 2100-1, 2100-2 may include at least one of a printed layer 1021, a glass member 2110, first coating portions 2120, 2120-1, 2120-2, or a second coating portion 2130. The glass assemblies 2100, 2100-1, 2100-2 may include, e.g., a multi-stage format printed layer (e.g., the printed layer 1200 of FIG. 6) as illustrated in FIG. 6.

According to an embodiment, the glass member 2110 may include an upper side 2110a, a lower side2110b facing the opposite direction of the upper side 2110a, and a lateral side 2110c connecting the upper side 2110a and the lower side2110b.

According to an embodiment, the glass member 2110 may have a thickness of 20 micrometers to 150 micrometers, but the disclosure is not limited thereto. For example, the glass member 2110 may be 25 micrometers to 35 micrometers. The glass member 2110 may include ultra-thin glass (UTG) or polyimide (PI).

According to an embodiment, the glass member 2110 may include a plurality of grooves 2111. The plurality of grooves 2111 may be disposed in a portion corresponding to the flexible region 2100b in the glass member 2110. By forming the plurality of grooves 2111 in the flexible region 2100b, the glass member 2110 may be bent more flexibly.

According to an embodiment, the first coating portions 2120, 2120-1, 2120-2 may be disposed to surround the lateral side 2110c of the glass member 2110. A portion of the first coating portions 2120, 2120-1, 2120-2 may be bonded to the lateral side 2110c of the glass member 2110. The first coating portions 2120, 2120-1, 2120-2 may be disposed to surround at least a portion of the surfaces of the glass member 2110 including the lateral side of the glass member 2110.

The first coating portions 2120, 2120-1, 2120-2 may be disposed such that a portion thereof contacts at least one of the upper side 2110a or the lower side2110b of the glass member 2110. A portion of the first coating portions 2120, 2120-1, 2120-2 may be bonded or attached to the upper side 2110a or the lower side2110b of the glass member 2110. For example, the first coating portions 2120, 2120-1, 2120-2 may be disposed to wrap the lateral side 2110c and the upper side 2110a of the glass member 2110.

According to an embodiment, a portion of the first coating portions 2120, 2120-1, 2120-2 may be filled within the plurality of grooves 2111 of the glass member 2110.

According to an embodiment, the refractive index of the first coating portions 2120, 2120-1, 2120-2 may be substantially the same as the refractive index of the glass member 2110. The first coating portions 2120, 2120-1, 2120-2 may be refractive index matched with the glass member 2110. By matching the refractive index of the first coating portions 2120, 2120-1, 2120-2 and the refractive index of the glass member 2110, the boundary surface between the first coating portions 2120, 2120-1, 2120-2 and the glass member 2110 may be inhibited from being visible from the outside. For example, the boundary surface formed on the lateral side 2110c of the glass member 2110, which extends about perpendicular to the front side of the flexible display 1000, may be inhibited from being visible from the outside through refractive index matching between the first coating portions 2120, 2120-1, 2120-2 and the glass member 2110.

According to an embodiment, the first coating portions 2120, 2120-1, 2120-2 and the second coating portion 2130 may have different modulus values. According to an embodiment, the first coating portions 2120, 2120-1, 2120-2 may have a relatively smaller modulus value than the second coating portion 2130. The first coating portions 2120, 2120-1, 2120-2 may have, e.g., relatively more flexible performance than the second coating portion 2130.

According to an embodiment, the first coating portions 2120, 2120-1, 2120-2 may be an elastic material. For example, the first coating portions 2120, 2120-1, 2120-2 may include acrylic, urethane, or silicone material, but the disclosure is not limited thereto. The glass assemblies 2100, 2100-1, 2100-2 may secure bending durability by the elasticity of the first coating portions 2120, 2120-1, 2120-2. Bending durability may refer to performance that is not damaged even with repeated bending of the flexible display 1000. The first coating portions 2120, 2120-1, 2120-2 may be, e.g., optically clear resin (OCR). The first coating portions 2120, 2120-1, 2120-2 may be referred to as, e.g., a first coating layer or a first elastic coating layer.

According to an embodiment, the second coating portion 2130 may be disposed to surround the outer side of the first coating portions 2120, 2120-1, 2120-2. A portion of the second coating portion 2130 may be bonded to the outer side of the first coating portions 2120, 2120-1, 2120-2. The second coating portion 2130 may be disposed to surround at least a portion of the surfaces of the first coating portions 2120, 2120-1, 2120-2 including the outer side of the first coating portions 2120, 2120-1, 2120-2.

According to an embodiment, the second coating portion 2130 may have a relatively larger modulus value than the first coating portions 2120, 2120-1, 2120-2. The second coating portion 2130 may have, e.g., relatively greater rigidity than the first coating portions 2120, 2120-1, 2120-2. The second coating portion 2130 may protect the first coating portions 2120, 2120-1, 2120-2 and the glass member 2110 disposed within the second coating portion 2130 from external impacts.

Adhesive force may be formed on the first coating portions 2120, 2120-1, 2120-2 having a relatively smaller modulus value. Due to this adhesive force, external foreign objects may adhere to the first coating portions 2120, 2120-1, 2120-2 and damage the glass assemblies 2100, 2100-1, 2100-2. If the second coating portion 2130 wraps the outside of the first coating portions 2120, 2120-1, 2120-2, the first coating portions 2120, 2120-1, 2120-2 are spatially separated from the external air layer, reducing damage by foreign objects. For example, the second coating portion 2130 may have a modulus of 0.1 MPa or more.

According to an embodiment, as the second coating portion 2130 having a relatively larger modulus value wraps the outside of the first coating portions 2120, 2120-1, 2120-2, the second coating portion 2130 may constrain the deformation of the first coating portions 2120, 2120-1, 2120-2.

According to an embodiment, the second coating portion 2130 may be an elastic material. For example, the second coating portion 2130 may include acrylic, urethane, or silicone material, but the disclosure is not limited thereto. The glass assemblies 2100, 2100-1, 2100-2 may secure bending durability by the elasticity of the second coating 2130. Bending durability may refer to performance that is not damaged even with repeated bending of the flexible display 1000. The second coating 2130 may be, e.g., optically clear resin (OCR). The second coating 2130 may be referred to as, e.g., a second coating layer or a second elastic coating layer.

According to an embodiment, among the surfaces where the first coatings 2120, 2120-1, 2120-2 and the second coating 2130 contact, a surface substantially perpendicular to the front side of the flexible display (e.g., the flexible display 1000 of FIG. 4) may be disposed to overlap the printed layer 1021. According to an embodiment, the printed layer 1021 may be disposed to overlap a surface substantially perpendicular to the front side of the flexible display 1000 among the surfaces where the first coatings 2120, 2120-1, 2120-2 and the second coating 2130 contact. According to an embodiment, the printed layer 1021 may be disposed to be orthogonal to a virtual plane including a surface substantially perpendicular to the front side of the flexible display 1000 among the surfaces where the first coatings 2120, 2120-1, 2120-2 and the second coating 2130 contact.

According to an embodiment, the first coatings 2120, 2120-1, 2120-2 and the second coating 2130 may be formed of a hyper elastic material. In the disclosure, by double coating the first coatings 2120, 2120-1, 2120-2 and the second coating 2130 with different modulus values, wrinkle phenomena occurring in bent (rolled or folded) portions may be mitigated.

Referring to FIG. 15A, the first coating 2120 may be disposed to contact the lateral side 1910c and the lower side1910b of the glass member 2110.

Referring to FIG. 15B, the first coating 2120-1 may be disposed to wrap the entire surface (the upper side 2110a, the lower side2110b, and the lateral side 2110c) of the glass member 2110. The first coating 2120-1 may be disposed to entirely wrap the surface of the glass member 2110.

Referring to FIG. 15C, the first coating 2120-2 may be disposed to wrap the entire surface (the upper side 2110a, the lower side2110b, and the lateral side 2110c) of the glass member 2110. As compared with the embodiment of FIG. 14B, the first coating 2120-2 may protrude more upward in the flexible region 2100b of the glass assembly 2100-2. The first coating 2120-2 may further include a protrusion 2121-2 protruding upward in the flexible region 2100b. By increasing the proportion of the first coating 2120-2 in the flexible region 2100b, bending performance may be enhanced.

According to an embodiment, a flexible display 1000 including a flexible region and a non-flexible region may include a glass member 1022, 1910, 2010, 2110, a first coating 1023, 1810, 1920, 2020, 2120 disposed to surround at least a portion of surfaces of the glass member 1022, 1910, 2010, 2110 including a lateral side of the glass member 1022, 1910, 2010, 2110, a second coating 1024, 1820, 1930, 2030, 2130 disposed to surround at least a portion of surfaces of the first coating 1023, 1810, 1920, 2020, 2120 including a lateral side of the first coating 1023, 1810, 1920, 2020, 2120 and having a modulus value different from the first coating 1023, 1810, 1920, 2020, 2120, and a display panel 1030 disposed under the glass member 1022, 1910, 2010, 2110.

According to an embodiment, a portion of the first coating 1023, 1810, 1920, 2020, 2120 may be disposed on at least one of an upper side or a lower sideof the glass member 1022, 1910, 2010, 2110.

According to an embodiment, the first coating 1023, 1810, 1920, 2020, 2120 may be configured such that a thickness applied in the flexible region is thicker than a thickness applied in the non-flexible region.

According to an embodiment, the first coating 1023, 1810, 1920, 2020, 2120 may form a step between the flexible region and the non-flexible region.

According to an embodiment, a refractive index of the glass member 1022, 1910, 2010, 2110 and a refractive index of the first coating 1023, 1810, 1920, 2020, 2120 may be substantially the same.

According to an embodiment, the second coating 1024, 1820, 1930, 2030, 2130 may have a relatively larger modulus value than the first coating 1023, 1810, 1920, 2020, 2120.

According to an embodiment, the first coating 1023, 1810, 1920, 2020, 2120 and the second coating 1024, 1820, 1930, 2030, 2130 may be formed of acrylic, urethane, or silicone material.

According to an embodiment, the flexible display 1000 may further include a printed layer 1021, 1200 disposed adjacent to an edge of the flexible display and configured to be impregnated in the second coating 1024, 1820, 1930, 2030, 2130.

According to an embodiment, the printed layer 1200 may include a first printed layer 1210 and a second printed layer 1220 having a width different from that of the first printed layer 1210. The first printed layer 1210 and the second printed layer 1220 may have a vertically stacked structure.

According to an embodiment, the printed layer 1021, 1200 may be disposed to vertically overlap an outer side of the first coating 1023, 1810, 1920, 2020, 2120.

According to an embodiment, the flexible display 1000 may further include a hard coating layer 1025 in film form disposed on the second coating 1024, 1820, 1930, 2030, 2130 to protect a surface of the second coating 1024, 1820, 1930, 2030, 2130.

According to an embodiment, the glass member 1022, 1910, 2010, 2110 may be formed such that a thickness of a portion corresponding to the flexible region is thinner than a thickness of a portion corresponding to the non-flexible region.

According to an embodiment, the glass member 1022, 1910, 2010, 2110 may further include a plurality of grooves or a plurality of holes formed in a portion corresponding to the flexible region to enhance flexibility.

According to an embodiment, an electronic device 200 may include a first housing 210, a second housing 220 movably coupled to the first housing 210, and a flexible display 1000 received in the first housing 210 and the second housing 220 and configured to be at least partially bent according to a position of the second housing 220 relative to the first housing 210. The flexible display 1000 may include a glass member 1022, 1910, 2010, 2110, a first coating 1023, 1810, 1920, 2020, 2120 applied to surround at least a portion of surfaces of the glass member 1022, 1910, 2010, 2110 including a lateral side of the glass member 1022, 1910, 2010, 2110, a second coating 1024, 1820, 1930, 2030, 2130 applied to surround at least a portion of surfaces of the first coating 1023, 1810, 1920, 2020, 2120 including a lateral side of the first coating 1023, 1810, 1920, 2020, 2120 and having a relatively larger modulus value than the first coating 1023, 1810, 1920, 2020, 2120, and a display panel 1030 disposed under the glass member 1022, 1910, 2010, 2110.

According to an embodiment, a refractive index of the glass member 1022, 1910, 2010, 2110 and a refractive index of the first coating 1023, 1810, 1920, 2020, 2120 may be substantially the same.

According to an embodiment, the second coating 1024, 1820, 1930, 2030, 2130 may have a relatively larger modulus value than the first coating 1023, 1810, 1920, 2020, 2120.

According to an embodiment, the first coating 1023, 1810, 1920, 2020, 2120 and the second coating 1024, 1820, 1930, 2030, 2130 may be formed of acrylic, urethane, or silicone material.

According to an embodiment, the flexible display 1000 may further include a printed layer 1021, 1200 disposed adjacent to a corner of the flexible display 1000 and configured to be impregnated in the second coating 1024, 1820, 1930, 2030, 2130.

According to an embodiment, the printed layer 1200 may include a first printed layer 1210 and a second printed layer 1220 having a width different from that of the first printed layer 1210. The first printed layer 1210 and the second printed layer 1220 may have a vertically stacked structure.

According to an embodiment, the printed layer 1021, 1200 may be disposed to vertically overlap an outer side of the first coating 1023, 1810, 1920, 2020, 2120.

The terms as used herein are provided merely to describe some embodiments thereof, but are not intended to limit the disclosure. As used herein, the singular forms "a," "an," and "the" are intended to include the plural forms as well, unless the context clearly indicates otherwise. As used herein, each of such phrases as "A or B," "at least one of A and B," "at least one of A or B," "A, B, or C," "at least one of A, B, and C," and "at least one of A, B, or C," may include all possible combinations of the items enumerated together in a corresponding one of the phrases. As used herein, the term 'and/or' should be understood as encompassing any and all possible combinations by one or more of the enumerated items. As used herein, the terms "include," "have," and "comprise" are used merely to designate the presence of the feature, component, part, or a combination thereof described herein, but use of the term does not exclude the likelihood of presence or adding one or more other features, components, parts, or combinations thereof. As used herein, the terms "first" and "second" may modify various components regardless of importance and/or order and are used to distinguish a component from another without limiting the components.

As used herein, the terms "configured to" may be interchangeably used with the terms "suitable for," "having the capacity to," "designed to," "adapted to," "made to," or "capable of" depending on circumstances. The term "configured to" does not essentially mean "specifically designed in hardware to." Rather, the term "configured to" may mean that a device can perform an operation together with another device or parts. For example, a 'device configured (or set) to perform A, B, and C' may be a dedicated device to perform the corresponding operation or may mean a general-purpose device capable of various operations including the corresponding operation.

Meanwhile, the terms "upper side", "lower side", and "front and rear directions" used in the disclosure are defined with respect to the drawings, and the shape and position of each component are not limited by these terms.

In the disclosure, the above-described description has been made mainly of specific embodiments, but the disclosure is not limited to such specific embodiments, but should rather be appreciated as covering all various modifications, equivalents, and/or substitutes of various embodiments.

## Claims

1. A flexible display (1000) including a flexible region and a non-flexible region, comprising:
a glass member (1022, 1910, 2010, 2110);
a first coating (1023, 1810, 1920, 2020, 2120) surrounding at least a portion of surfaces of the glass member (1022, 1910, 2010, 2110) including a lateral side of the glass member (1022, 1910, 2010, 2110);
a second coating (1024, 1820, 1930, 2030, 2130) disposed to surround at least a portion of surfaces of the first coating (1023, 1810, 1920, 2020, 2120) including a lateral side of the first coating (1023, 1810, 1920, 2020, 2120), and having a modulus value different from a modulus value of the first coating (1023, 1810, 1920, 2020, 2120); and
a display panel (1030) disposed under the glass member (1022, 1910, 2010, 2110).

2. The flexible display of claim 1, wherein a portion of the first coating (1023, 1810, 1920, 2020, 2120) is disposed on at least one of a top surface or a bottom surface of the glass member (1022, 1910, 2010, 2110).

3. The flexible display of claim 1 or 2, wherein the first coating (1023, 1810, 1920, 2020, 2120) is configured such that a portion applied in the flexible region is thicker than a portion applied in the non-flexible region.

4. The flexible display of claim 3, wherein the first coating (1023, 1810, 1920, 2020, 2120) forms a step between the flexible region and the non-flexible region.

5. The flexible display of any one of claims 1 to 4, wherein a refractive index of the glass member (1022, 1910, 2010, 2110) and a refractive index of the first coating (1023, 1810, 1920, 2020, 2120) are substantially the same.

6. The flexible display of any one of claims 1 to 5, wherein the second coating (1024, 1820, 1930, 2030, 2130) has a modulus value relatively greater than that of the first coating (1023, 1810, 1920, 2020, 2120).

7. The flexible display of any one of claims 1 to 6, further comprising a printed layer (1021, 1200) disposed adjacent to an edge of the flexible display and configured to be impregnated in the second coating (1024, 1820, 1930, 2030, 2130), wherein the printed layer (1021, 1200) is arranged to vertically overlay an outer side of the first coating (1023, 1810, 1920, 2020, 2120).

8. The flexible display of claim 7, wherein the printed layer (1200) comprises:
a first printed layer (1210); and
a second printed layer (1220) having a width different from a width of the first printed layer (1210), wherein the first printed layer (1210) and the second printed layer (1220) have a vertically stacked structure.

9. The flexible display of any one of claims 1 to 8, wherein a portion of the glass member (1022, 1910, 2010, 2110) corresponding to the flexible region is relatively thinner than a portion of the glass member corresponding to the non-flexible region.

10. The flexible display of any one of claims 1 to 9, wherein the glass member (1022, 1910, 2010, 2110) further includes a plurality of grooves or a plurality of holes formed in a portion of the glass member corresponding to the flexible region to improve flexibility.

11. An electronic device comprising:
a first housing (210);
a second housing (220) movably coupled to the first housing (210); and
a flexible display (1000) received in the first housing (210) and the second housing (220) and configured to be at least partially bent according to a position of the second housing (220) relative to the first housing (210), wherein the flexible display (1000) includes:
a glass member (1022, 1910, 2010, 2110);
a first coating (1023, 1810, 1920, 2020, 2120) surrounding at least a portion of surfaces of the glass member (1022, 1910, 2010, 2110) including a lateral side of the glass member (1022, 1910, 2010, 2110);
a second coating (1024, 1820, 1930, 2030, 2130) disposed to surround at least a portion of surfaces of the first coating (1023, 1810, 1920, 2020, 2120) including a lateral side of the first coating (1023, 1810, 1920, 2020, 2120); and
a display panel (1030) disposed under the glass member (1022, 1910, 2010, 2110).

12. The electronic device of claim 11, wherein a refractive index of the glass member (1022, 1910, 2010, 2110) and a refractive index of the first coating (1023, 1810, 1920, 2020, 2120) are substantially the same.

13. The electronic device of claim 11 or 12, wherein the second coating (1024, 1820, 1930, 2030, 2130) has a relatively larger modulus value than a modulus value of the first coating (1023, 1810, 1920, 2020, 2120).

14. The electronic device of any one of claims 11 to 13, wherein the flexible display (1000) further includes a printed layer (1021, 1200) disposed adjacent to a corner of the flexible display (1000) and configured to be impregnated in the second coating (1024, 1820, 1930, 2030, 2130), and wherein the printed layer (1021, 1200) is disposed to vertically overlap an outer side of the first coating (1023, 1810, 1920, 2020, 2120).

15. The electronic device of claim 14, wherein the printed layer (1200) includes:
a first printed layer (1210); and
a second printed layer (1220) having a width different from that of the first printed layer (1210), wherein the first printed layer (1210) and the second printed layer (1220) have a vertically stacked structure.
